# EUROPEAN PATENT APPLICATION

(11) **EP 4 411 712 A1**
(43) Date of publication of application: **07.08.2024**
(21) Application number: 24150604.7
(22) Date of filing: 06.01.2024
(51) Int. Cl.: G09G 3/3233

(54) **DISPLAY PANEL AND DISPLAY APPARATUS**

(30) Priority: 31.01.2023 KR 20230012490
(71) Applicant: LG Display Co., Ltd., Seoul 07336 (KR)
(72) Inventor: KANG, In, 245, LG-ro, Wollong-Myeon, Paju-si, Gyeonggi-do, 10845 (KR); JUNG, DaeSung, 245, LG-ro, Wollong-Myeon, Paju-si, Gyeonggi-do, 10845 (KR); KIM, DaeKyu, 245, LG-ro, Wollong-Myeon, Paju-si, Gyeonggi-do, 10845 (KR); KIM, JeongHo, 245, LG-ro, Wollong-Myeon, Paju-si, Gyeonggi-do, 10845 (KR)
(74) Representative: Bryn-Jacobsen, Caelia

(57) **Abstract**

Disclosed is a display panel capable of adjusting a ratio of a plurality of areas capable of independently controlling a viewing angle in a display area, wherein the display panel includes a plurality of mode control line sets individually connected to a plurality of pixel blocks, wherein each of the plurality of mode control line sets includes a first mode control line for supplying a first mode control signal and a second mode control line for supplying a second mode control signal, and wherein each of the plurality of subpixels includes a driving transistor connected to a first power line, a first light emitting device connected to the driving transistor through a first mode control transistor controlled by the first mode control signal, a second light emitting device connected to the driving transistor through a second mode control transistor controlled by the second mode control signal, a first lens region disposed on the first light emitting device, and a second lens region disposed on the second light emitting device, wherein the first lens region and the second lens region differently control a viewing angle in a first direction.

## Description

### CROSS-REFERENCE TO RELATED APPLICATIONS

This application claims the benefit of the Korean Patent Application No. 10-10-2023-0012490 filed on January 31, 2023.

### BACKGROUND

### Field of the Invention

The present disclosure relates to a display panel and a display apparatus which adjust a ratio of a plurality of areas capable of independently controlling a viewing angle in a display area.

### Description of the Related Art

Electronic apparatuses of various fields include a display apparatus for displaying an image. For example, a plurality of display apparatuses for providing desired information or content to a driver and a passenger may be applied to a vehicle.

Among the display apparatuses mounted on the vehicle, the display apparatus disposed at the center of a dashboard has been increased in size.

The display apparatus may include a first region of a wide viewing angle mode for a driver and a passenger of a passenger seat, and a second region capable of switching a wide viewing angle mode and a narrow viewing angle mode.

The display apparatus requires a method capable of freely adjusting a ratio of the first region and the second region according to a user request or content.

The above-described background is part of the present disclosure to devise the present disclosure or is technical information acquired by a process of devising the present disclosure, but may not be regarded as the known art disclosed to the general public before the present disclosure is disclosed.

### SUMMARY

Accordingly, the present disclosure is directed to providing a display panel and a display apparatus that substantially obviate one or more problems due to limitations and disadvantages of the related art.

An aspect of the present disclosure provides a display panel and a display apparatus which adjust a ratio of a plurality of areas capable of independently controlling a viewing angle in a display area.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

To achieve these and other advantages and in accordance with the purpose of the disclosure, as embodied and broadly described herein, there is provided a display panel comprising a plurality of pixel blocks including a plurality of subpixels disposed in a display area, a bezel area disposed outside the display area, and a plurality of mode control line sets individually connected to the plurality of pixel blocks, wherein each of the plurality of mode control line sets includes a first mode control line for supplying a first mode control signal and a second mode control line for supplying a second mode control signal, and wherein each of the plurality of subpixels includes a driving transistor connected to a first power line, a first light emitting device connected to the driving transistor through a first mode control transistor controlled by the first mode control signal, a second light emitting device connected to the driving transistor through a second mode control transistor controlled by the second mode control signal, a first lens region disposed on the first light emitting device, and a second lens region disposed on the second light emitting device, wherein the first lens region and the second lens region differently control a viewing angle in a first direction.

In accordance with another aspect of the present disclosure, there is provided a display apparatus comprising a display panel, a data driver disposed in a bezel area and configured to drive data lines disposed in a display area, wherein the data driver individually supplies a first mode control signal and a second mode control signal to each of a plurality of mode control line sets.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate examples of the disclosure and together with the description serve to explain the principle of the disclosure. In the drawings:
FIG. 1 schematically illustrates a configuration of a display apparatus according to one example of the present disclosure;
FIG. 2 illustrates a structure in which a display apparatus according to one example of the present disclosure is applied to a vehicle;
FIGs. 3A to 3D illustrate various shapes in which a ratio of first and second regions is changed in a display panel according to one example of the present disclosure;
FIGs. 4A and 4B are perspective views illustrating first and second lens structures of a display panel according to one example of the present disclosure;
FIG. 5 is a plan view illustrating a pixel structure of a display panel according to one example of the present disclosure;
FIG. 6 is a cross-sectional view illustrating a first lens region along I-I' of FIG. 5;
FIG. 7 is a cross-sectional view illustrating a second lens region along II-II' of FIG. 5;
FIG. 8 is an equivalent circuit diagram illustrating a configuration of a subpixel in a display panel according to one example of the present disclosure;
FIG. 9 is a diagram illustrating a schematic layout structure of first and second mode control lines in a portion of a display panel according to one example of the present disclosure;
FIG. 10 is a diagram illustrating a schematic layout structure of a bezel area shown in FIG. 9;
FIG. 11 is a diagram illustrating a schematic layout structure of first and second mode control lines in a portion of a display panel according to one example of the present disclosure;
FIG. 12 is a diagram illustrating a schematic layout structure of a bezel area shown in FIG. 11;
FIG. 13 is a diagram illustrating an arrangement structure of main signal lines in a first type pixel region illustrated in FIGs. 9 and 11;
FIG. 14 is a diagram illustrating an arrangement structure of main signal lines in a second type pixel region illustrated in FIGs. 9 and 11;
FIG. 15 is a diagram illustrating an arrangement structure of main signal lines in a third type pixel area illustrated in FIGs. 9 and 11;
FIG. 16 is a plan view illustrating a pixel arrangement structure in a display panel according to one example of the present disclosure; and
FIG. 17 is a diagram illustrating an arrangement structure of a plurality of pixel blocks in a display apparatus according to one example of the present disclosure.

### DETAILED DESCRIPTION OF THE DISCLOSURE

Advantages and features of the present disclosure, and implementation methods thereof will be clarified through following aspects described with reference to the accompanying drawings. The present disclosure may, however, be embodied in different forms and should not be construed as limited to the aspects set forth herein. Rather, these aspects are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing aspects of the present disclosure are merely an example, and thus, the present disclosure is not limited to the illustrated details. Like reference numerals refer to like elements throughout the specification. In the following description, when the detailed description of the relevant known function or configuration is determined to unnecessarily obscure the important point of the present disclosure, the detailed description will be omitted. In a case where 'comprise', 'have', and 'include' described in the present specification are used, another part may be added unless 'only' is used. The terms of a singular form may include plural forms unless referred to the contrary.

In construing an element, the element is construed as including an error range although there is no explicit description.

In describing a position relationship, for example, when a position relation between two parts is described as "on, " "over, " "under, " and "next, " one or more other parts may be disposed between the two parts unless a more limiting term, such as "just" or "direct (ly) " is used.

In describing a time relationship, for example, when the temporal order is described as, for example, "after, " "subsequent, " "next, " and "before, " a case which is not continuous may be included unless a more limiting term, such as "just, " "immediate (ly), " or "direct (ly) " is used.

It will be understood that, although the terms "first, " "second, " etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

In describing the elements of the present disclosure, the terms "first, " "second, " "A, " "B, " " (a), " " (b), " etc., may be used. These terms are intended to identify the corresponding elements from the other elements, and basis, order, or number of the corresponding elements should not be limited by these terms. As for the expression that an element or a layer is "connected, " "coupled, " or "adhered" to another element or layer, the element or layer may not only be directly connected or adhered to another element or layer, but also be indirectly connected or adhered to another element or layer with one or more intervening elements or layers "disposed" between the elements or layers, unless otherwise specified.

The term "at least one" should be understood as including any and all combinations of one or more among the associated listed elements. For example, the meaning of "at least one or more of a first element, a second element, and a third element" denotes the combination of all elements proposed from two or more of the first element, the second element, and the third element as well as the first element, the second element, or the third element.

Features of various aspects of the present disclosure may be partially or overall coupled to or combined with each other, and may be variously inter-operated with each other and driven technically as those skilled in the art may sufficiently understand. The aspects of the present disclosure may be carried out independently from each other, or may be carried out together in co-dependent relationship.

Hereinafter, the aspect of the present disclosure will be described with reference to the accompanying drawings. Since a scale of each of elements shown in the accompanying drawings is different from an actual scale for convenience of description, the present disclosure is not limited to the shown scale. Further, all the components of each display apparatus according to all aspects of the present disclosure are operatively coupled and configured.

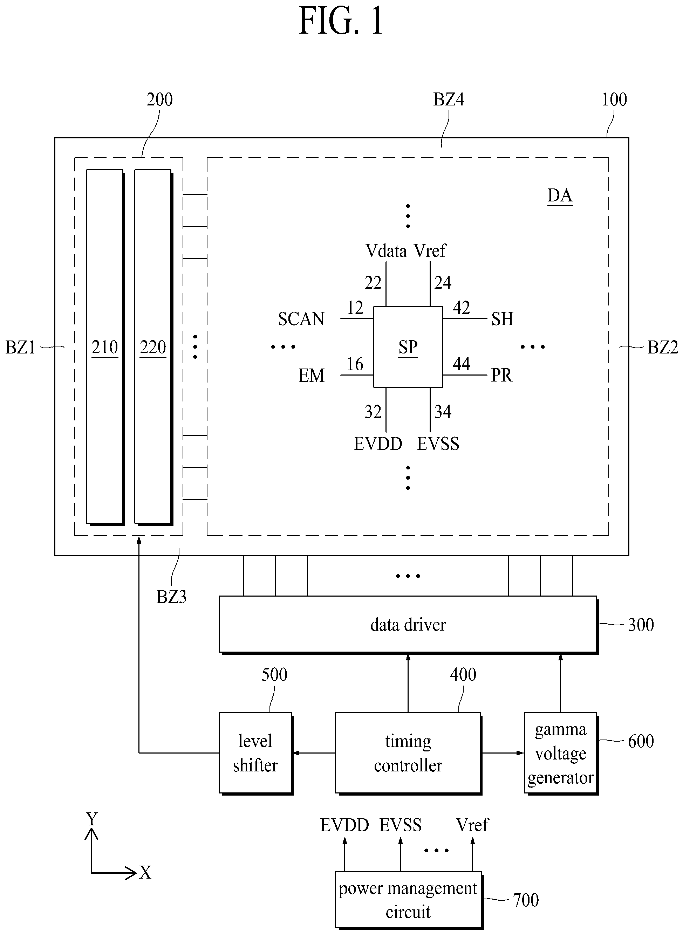

FIG. 1 is a block diagram schematically illustrating a configuration of a display apparatus according to one example of the present disclosure.

The display apparatus according to one example of the present disclosure may be an electroluminescent display apparatus including an organic light emitting diode OLED display apparatus, a quantum dot light emitting diode display apparatus, or an inorganic light emitting diode display apparatus.

Referring to FIG. 1, the display apparatus according to one example of the present disclosure may include a display panel 100, a gate driver 200 embedded in the display panel 100, a data driver 300 connected to the display panel 100, a timing controller 400 for controlling the gate driver 200 and the data driver 300, a gamma voltage generator 600, and a power management circuit 700. According to one example of the present disclosure, the display apparatus may further include a level shifter 500 connected between the timing controller 400 and the gate driver 200. According to one example of the present disclosure, the data driver 300, the timing controller 400, the gamma voltage generator 600, and the level shifter 500 may be integrated into a display driver.

The display panel 100 may be a rigid display panel or a flexible display panel enabling a shape change, such as a foldable display panel, a bendable display panel, a rollable display panel, or a stretchable display panel.

The display panel 100 may include a display area DA for displaying an image, and a bezel area BZ 1 to BZ4 configured to surround the display area DA and positioned in the periphery of the display area DA.

The display panel 100 may display an image by using the display area DA with a plurality of subpixels SP arranged in a matrix configuration. The pixel matrix disposed in the display area DA may include a plurality of row and column lines provided with the plurality of subpixels SP.

Each subpixel SP may be any one of a red subpixel for emitting red light, a green subpixel for emitting green light, a blue subpixel for emitting blue light, and a white subpixel for emitting white light. A unit pixel may include at least two subpixels SP.

A plurality of signal lines including a data line 12, gate lines 12 and 16, power lines 24, 32 and 34, and mode control lines 42 and 44, which are connected to each subpixel S, may be disposed in the display panel 100.

The data line 12 may supply a data voltage Vdata supplied from the data driver 300 to each subpixel SP.

Any one gate line 12 of the gate lines 12 and 16 may supply a scan signal SCAN supplied from the gate driver 200 to each subpixel SP, and the other gate line 16 may supply an emission control signal EM supplied from the gate driver 12 to each subpixel SP.

An initialization voltage line 24 among the power lines 24, 32 and 34 may supply an initialization voltage Vref supplied from the power management circuit 700 to each subpixel SP. A first power line 32 may supply a high potential power voltage EVDD to each subpixel SP and a second power line 34 may supply a low potential power voltage EVSS to each subpixel SP through a common electrode (cathode electrode).

A first mode control line 42 of the mode control lines 42 and 44 may supply a first mode control signal SH supplied from the data driver 300 or a separate mode controller (not shown) to each subpixel SP, and a second mode control line 44 may supply a second mode control signal PR supplied from the separate mode controller to each subpixel SP.

Each subpixel SP may include a pixel circuit comprising first and second light emitting devices and a plurality of transistors for independently driving the first and second light emitting devices, a first lens region disposed on the first light emitting device, and a second lens region disposed on the second light emitting device. The first lens region and the second lens region may differently control a light emitting angle, that is, a viewing angle.

For example, each subpixel SP drives the first light emitting device to implement a wide viewing angle mode or a share mode through the first lens region. Each subpixel SP drives the second light emitting device to implement a narrow viewing angle mode or a privacy mode for limiting a viewing angle to be smaller than the wide viewing angle mode through the second lens region.

The display apparatus or the display panel 100 may selectively drive the first light emitting device and the second light emitting device of each subpixel SP by using the mode control signal SH and PR, to thereby control the viewing angle of each subpixel SP. The display device or the display panel 100 selectively drives the first and second light emitting devices in each subpixel SP by using the mode control signal SH and PR, whereby the display area DA may be divided into a plurality of areas capable of being controlled at different viewing angles, and a ratio or size in the plurality of areas may be freely adjusted in a first direction X and a second direction Y. A detailed description thereof will be provided as follows.

For example, any one of the plurality of areas of the display area DA may operate in the wide viewing angle mode through the first lens region by driving the first light emitting device in each subpixel SP, and may operate in the narrow viewing angle mode through the second lens region by driving the second light emitting device in each subpixel SP. Another of the plurality of areas may operate in the narrow viewing angle mode through the second lens region by driving the second light emitting device, and may operate in the wide viewing angle mode through the first lens region by driving the first light emitting device. The plurality of areas may be respectively driven in different viewing angle modes or may be driven in the same viewing angle mode.

The display panel 100 according to one example of the present disclosure may further include a touch sensor screen disposed in the display area DA and configured to sense a user's touch.

The display panel 100 according to one example of the present disclosure may be a touch display panel in which a touch sensor array is embedded. According to one example of the present disclosure, the display panel 100 may comprise a pixel array including a circuit device layer having a plurality of transistors disposed on a substrate and a light emitting device layer having a plurality of light emitting devices disposed on the circuit device layer, an encapsulation layer disposed on the pixel array and configured to seal the light emitting device layer, a touch sensor array including a plurality of touch electrodes disposed on the encapsulation layer, and a lens array including first and second lenses disposed on the touch sensor array. The display panel 100 according to one example of the present disclosure may further include an optical film, an optical clear adhesive OCA, a cover substrate, a protection film, and the like, which are sequentially disposed on the lens array. The display panel 100 according to one example of the present disclosure may further include a color filter array including a color filter and a black matrix disposed between the touch sensor array and the lens array.

The gate driver 200 may be disposed on at least one of a plurality of bezel areas BZ1 and BZ2 located in the periphery of the display area DA. For example, the gate driver 200 may be disposed on any one of the first and second bezel areas BZ1 and BZ2 facing each other with the display area DA interposed therebetween or may be disposed on both sides of the first and second bezel areas BZ1 and BZ2. The gate driver 200 may be disposed in a gate-gate-in-panel GIP type including transistors formed in the same process as transistors disposed in the display area DA.

The gate driver 200 may include a scan driver 210 for driving at least any one gate line 12 of the plurality of gate lines 12 and 16 connected to the subpixels SP of each pixel row line, and an emission control driver 220 for driving the other gate line 16.

The number of gate lines 12 and 16 connected to the subpixels SP of each pixel row line, the number of scan drivers 210 connected to the subpixels SP of each pixel row line, and the number of emission control drivers 220 connected to the subpixels SP of each pixel row line are not limited to those illustrated in FIG. 1, and may be variously changed according to a detailed configuration of the pixel circuit constituting each subpixel SP.

Each of the scan driver 210 and the emission control driver 220 may operate by receiving a plurality of gate control signals supplied from the timing controller 400 through the level shifter 500. In one example of the present disclosure, each of the scan driver 210 and the emission control driver 220 may be supplied with the plurality of gate control signals from the timing controller 400.

The level shifter 500 may receive control signals from the timing controller 400, may generate the plurality of gate control signals by performing level shifting or logic processing, and may supply the gate control signals to the scan driver 210 and the emission control driver 220.

The scan driver 210 may supply at least one scan signal SCAN to each of the plurality of pixel row lines using the plurality of gate control signals supplied from the level shifter 500 or the timing controller 400. The scan driver 210 may supply the scan signal SCAN to at least one gate line 12 of the plurality of gate lines 12 and 16 connected to the subpixels SP of each pixel row line.

The emission control driver 220 may supply the plurality of emission control signals to each of the plurality of pixel lines by using the plurality of gate control signals supplied from the level shifter 500 or the timing controller 400. The emission control driver 220 may supply the emission control signal EM to at least one gate line 16 of the plurality of gate lines 12 and 16 connected to the subpixels SP of each pixel row line.

The plurality of transistors disposed in the display area DA of the display panel 100 and the bezel area BZ1 to BZ4 including the gate driver 200 may be applied with at least any one of an LTPS transistor using low temperature polysilicon LTPS semiconductor and an oxide transistor using metal-oxide semiconductor. The display panel 100 according to one example of the present disclosure may be configured such that the LTPS transistor and the oxide transistor coexist to reduce power consumption.

The gamma voltage generator 600 may generate a plurality of reference gamma voltages having different voltage levels and may supply the reference gamma voltages to the data driver 300. The gamma voltage generator 600 may generate the plurality of reference gamma voltages corresponding to the gamma characteristics of the display apparatus under the control of the timing controller 400 and may supply the reference gamma voltages to the data driver 300. In one example of the present disclosure, the gamma voltage generator 600 may adjust reference gamma voltage levels according to gamma data supplied from the timing controller 400 and may output the reference gamma voltage levels to the data driver 300.

The data driver 300 may convert digital data supplied together with data control signals from the timing controller 400 into an analog data signal and may supply each data voltage Vdata to each data line 22 of the display panel 100. The data driver 300 may subdivide the plurality of reference gamma voltages supplied from the gamma voltage generator 600 and may convert the digital data into the analog data voltage by using the subdivided gamma voltages.

The data driver 300 may include at least one data drive integrated circuit IC for driving the plurality of data lines DL disposed on the display panel 100. Each data drive IC may be mounted on each circuit film and may be connected to the display panel 100. The circuit film on which the data drive IC is mounted may be bonded and connected to the bezel area BZ3 in which a pad area of the display panel 100 is disposed through an anisotropic conductive film ACF. The circuit film may use any of a chip on film COF, a flexible printed circuit FPC, or a flexible flat cable FFC.

According to one example of the present disclosure, the data driver 300 generates the mode control signal SH and PR and supplies the generated mode control signal to the mode control lines 42 and 44 of the display panel 100, respectively. According to one example of the present disclosure, the mode control signal SH and PR may be generated in the mode controller separated from the data driver 300 and may be supplied to the display panel 100 through the circuit film on which the data drive IC is mounted.

The timing controller 400 may control the gate driver 200 and the data driver 300 by using timing control signals supplied from a host system and timing setting information stored therein.

The timing controller 400 according to one example of the present disclosure may generate the plurality of gate control signals for controlling the driving timing of the gate driver 200 and may supply the gate control signals to the gate driver 200. According to one example of the present disclosure, the timing controller 400 may generate the control signals for the timing control to generate the plurality of gate control signals in the level shifter 500 and to supply the generated gate control signals to the gate driver 200, and may supply the generated control signals to the level shifter 500.

The timing controller 400 may generate the plurality of data control signals for controlling the driving timing of the data driver 300 and may supply the data control signals to the data driver 300. According to one example of the present disclosure, the timing controller 400 may perform various image processing including image quality correction, deterioration correction and luminance correction for reduction of power consumption by receiving input image data and may supply the image-processed data to the data driver 300.

The power management circuit 700 may generate and supply a plurality of driving voltages required for operation of all circuit configurations of the display apparatus by using an input voltage. The power management circuit 700 may generate the first power supply voltage EVDD, the second power supply voltage EVSS, and the initialization voltage (reference voltage) Vref and may supply the generated voltages to the display panel 100. The power management circuit 700 may generate and supply various driving voltages required for the operation of the gate driver 200, the data driver 300, the timing controller 400, the level shifter 500, and the gamma voltage generator 600.

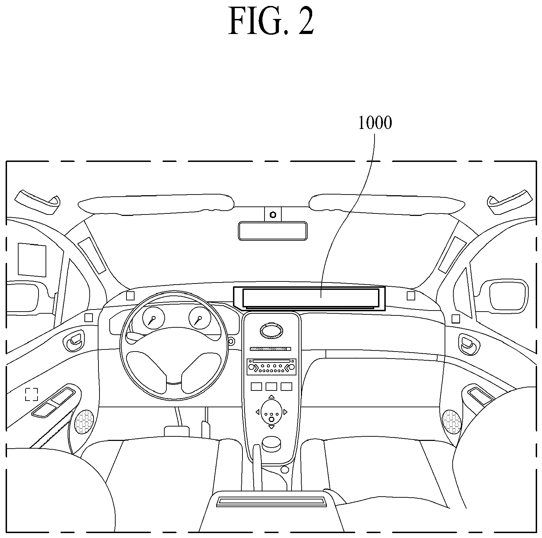

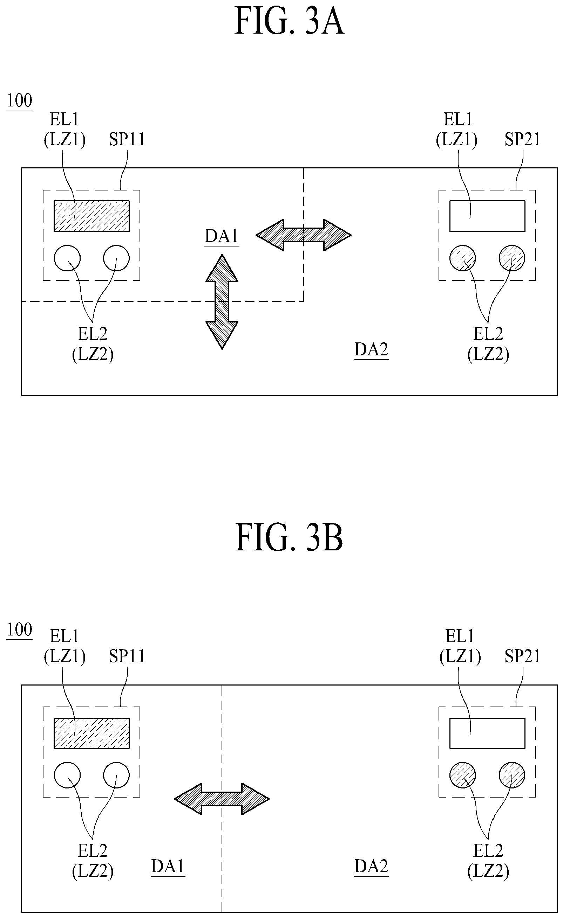

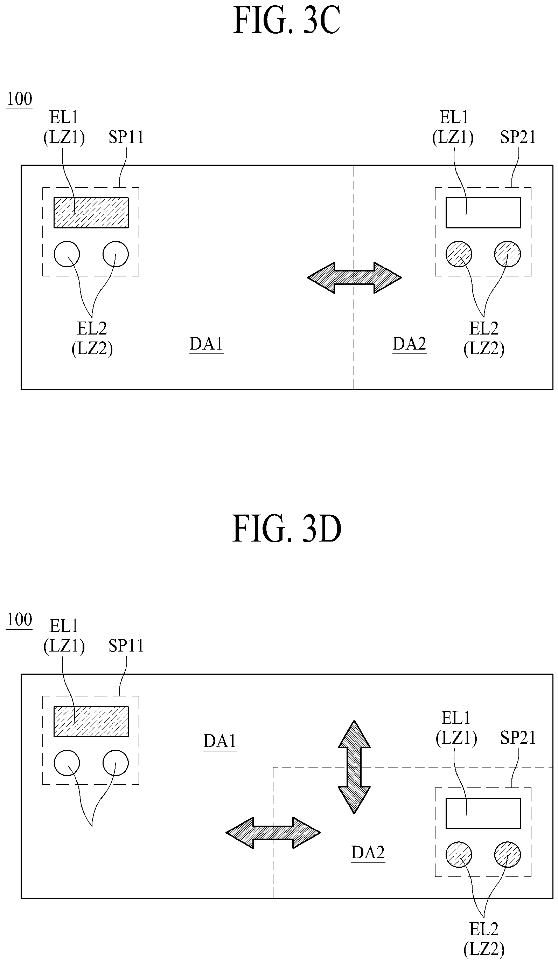

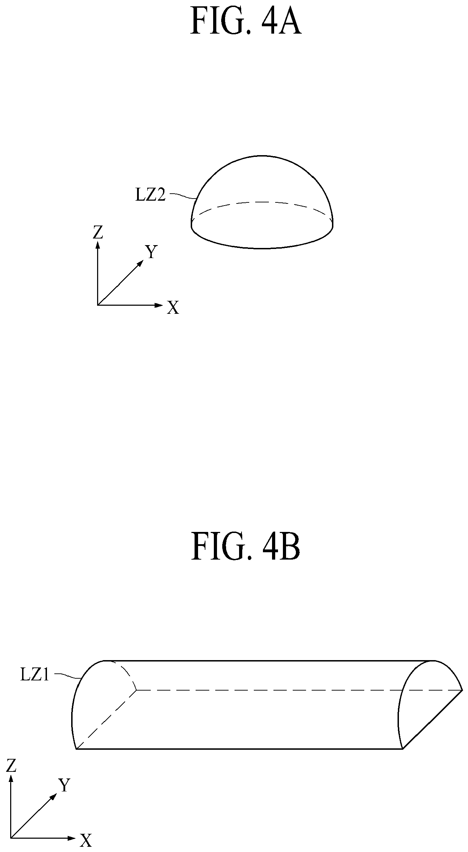

FIG. 2 illustrates a structure in which the display apparatus according to one example of the present disclosure is applied to a vehicle, and FIGs. 3A to 3D illustrate shapes in which a ratio of first and second areas is changed in the display panel according to one example of the present disclosure. FIGs. 4A and 4B are perspective views illustrating first and second lens structures of a subpixel according to one example of the present disclosure.

Referring to FIGs. 2 to 3D, a display apparatus 1000 according to one example of the present disclosure may be disposed at the center of a dashboard of a vehicle to provide an image to both a driver and a passenger of a passenger seat. A display panel 100 of the display apparatus 1000 may include a first area DA1 and a second area DA2, and a ratio or size of the first area DA1 and the second area DA2 may be varied in first and second directions.

According to one example of the present disclosure, the first area DA1 may be expressed as a center information display CID area or a share mode area, and the second area DA2 may be expressed as a co-driver display CDD area or a switchable privacy mode area.

Referring to FIGs. 3A to 4D, each of subpixels SP11 of the first area DA1 and each of subpixels SP21 of the second area DA2 may include a first light emitting device EL1, a second light emitting device EL2, a first lens LZ1 disposed on the first light emitting device EL1, and a second lens LZ2 disposed on the second light emitting device EL2.

In the example of the present disclosure, the first lens LZ1 may be disposed on a light traveling path of the first light emitting device EL1. The second lens LZ2 may be disposed on a light traveling path of the second light emitting device EL2.

In each of the subpixels SP11 and SP21, the second light emitting device EL2 may include a plurality of second light emitting devices EL2 or a plurality of second light emitting areas, and the plurality of second lenses LZ2 may be individually disposed in the light traveling paths of the plurality of second light emitting devices EL2 or the plurality of second light emitting areas. The plurality of second light emitting devices EL2 or the plurality of second light emitting areas may be connected in parallel in each of the subpixels SP11 and SP21.

The region in which the first lens LZ1 is arranged in each of the subpixels SP11 and SP21 may be expressed as the first lens region, and the region in which the plurality of second lenses LZ2 are arranged in each of the subpixels SP11 and SP21 may be expressed as the second lens region.

Referring to FIG. 4A, the first lens LZ1 may be a half-cylindrical lens elongated in the first direction X. Referring to FIG. 4B, the second lens LZ2 may be a half-spherical lens.

In FIGs. 4A and 4B, the first direction X may be expressed in the left-and-right direction, horizontal direction, or X-axis direction. The second direction Y may be expressed in the up-and-down direction, vertical, or Y-axis direction. The third direction Z may be expressed in the front-and-rear direction, thickness direction of the display panel 100, or Z-axis direction.

The first lens LZ1 and the second lens LZ2 may differently control (limit) the viewing angle in the left-and-right direction X and may equally control (limit) the viewing angle in the up-and-down direction Y.

For example, the first lens LZ1 may control the viewing angle to the wide viewing angle because the traveling path of light emitted from the first light emitting device EL1 is not limited within a specific angle in the left-and-right direction X, and the second lens LZ2 may control the viewing angle to the narrow viewing angle because the traveling path of light emitted from the second light emitting device EL2 is limited within a specific angle in the left-and-right direction X.

Both the first lens LZ1 and the second lens LZ2 may control the viewing angle at the narrow viewing angle by limiting the light traveling path within a specific angle in the vertical direction Y. Accordingly, in one example of the present disclosure, when the display apparatus 1000 is applied to the vehicle as shown in FIG. 2, it is possible to prevent an image displayed on the first and second areas DA1 and DA2 of the display panel 100 from being reflected on a front glass of the vehicle, to thereby prevent a driver 's view from being disturbed.

If the first light emitting device EL1 is driven in each of the subpixels SP11 and SP21, the corresponding subpixel may operate in the wide viewing angle mode in which the viewing angle of the left-and-right direction X is not limited. If the second light emitting device EL2 is driven in each of the subpixels SP11 and SP21, the corresponding subpixel may operate in the narrow viewing angle mode for limiting the viewing angle of the left-and-right direction X. The wide viewing angle mode may be expressed as the first mode, and the narrow viewing angle mode may be expressed as the second mode.

In each of the subpixels SP11 and SP21, the driving of the first light emitting device EL1 and the driving of the second light emitting device EL2 are switched based on the mode control signal SH and PR (FIG. 1) so that each of the subpixels SP11 and SP21 may switch the driving of the wide viewing angle and the driving of the narrow viewing angle.

Referring to FIGs. 3A to 3D, the display apparatus 1000 according to one example of the present disclosure selectively drives the first and second light emitting devices EL1 and EL2 in each of the subpixels SP11 and SP21 by using the mode control signal SH and PR (FIG. 1) so that it is possible to independently control the viewing angle of the first area DA1 and the second area DA2 and to freely adjust the ratio or size of the first area DA1 and the second area DA2 in the left-and-right direction X and the up-and-down direction Y.

For example, the first area DA1 of the display panel 100 drives the first light emitting device EL1 corresponding to the first lens LZ1 in each subpixel SP11, to thereby provide the image with the wide viewing angle in the left and right directions to the driver and the passenger.

The second area DA2 of the display panel 100 drives the second light emitting device EL2 corresponding to the second lens LZ2 in each subpixel SP21, to thereby provide the image having the narrow viewing angle in the left and right direction to the passenger so as not to disturb the driving of driver.

According to one example of the present disclosure, when the driver does not drive, the first light emitting device EL1 corresponding to the first lens LZ1 is driven in each of the subpixels SP11 and SP21, whereby the first area DA1 and the second area DA2 of the display panel 100 provide the image having the wide viewing angle in the left-and-right direction to the driver and the passenger.

The display apparatus 1000 according to one example of the present disclosure is not limited to the display apparatus for vehicle and may be applied to various display apparatuses such as a mobile display apparatus, an IT display apparatus, and a TV display apparatus.

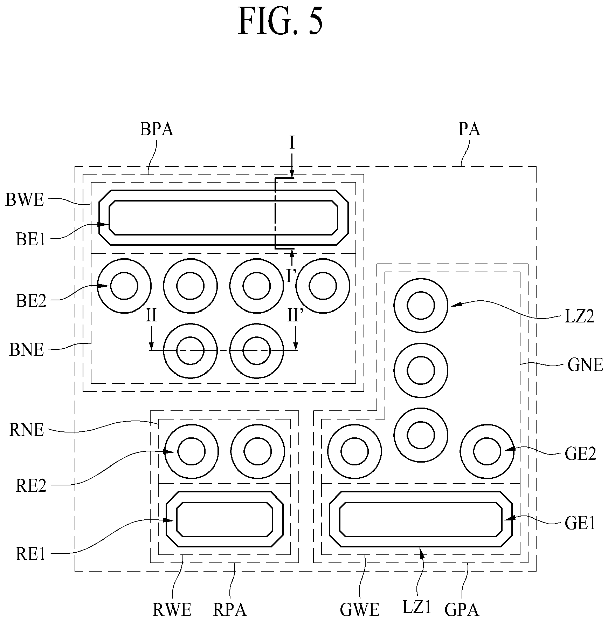

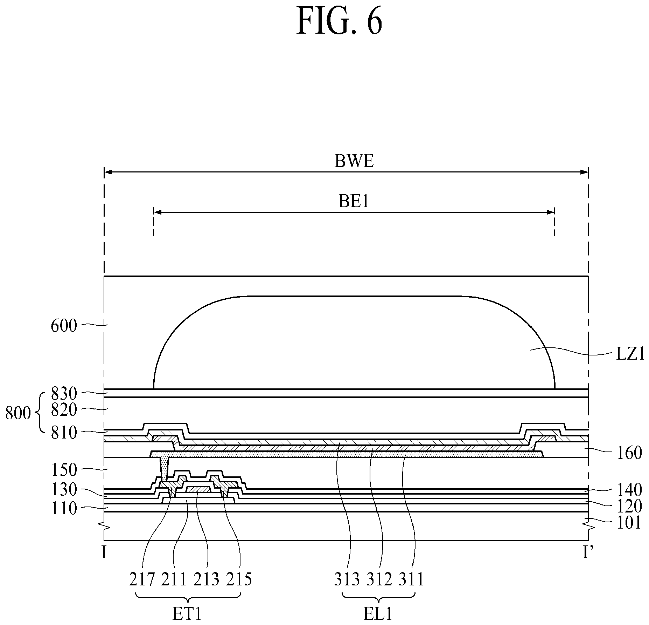

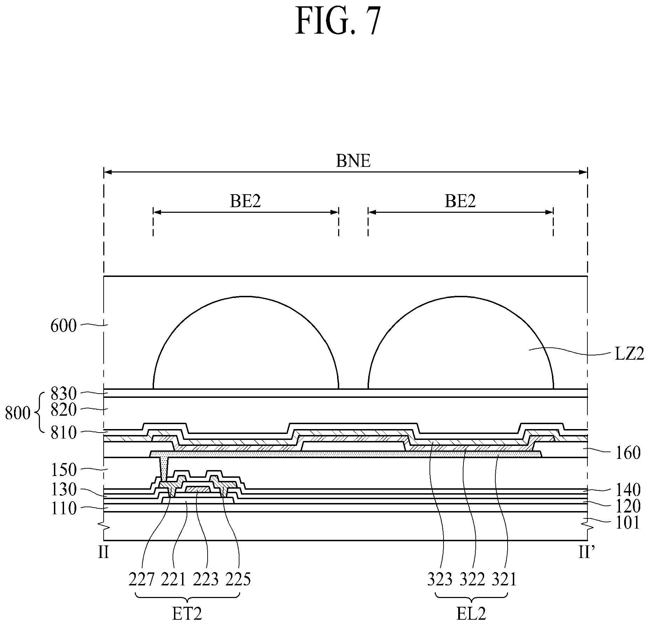

FIG. 5 is a plan view illustrating a cell structure of a display panel according to one example of the present disclosure, FIG. 6 is a cross-sectional view of a first lens region along I-I' of FIG. 5, and FIG. 7 is a cross-sectional view of a second lens region along II-II' of FIG. 5.

Referring to FIG. 5, a pixel area PA or a pixel according to one example of the present disclosure may include a blue B subpixel area BPA emitting blue light, a red R subpixel area RPA emitting red light, and a green G subpixel area GPA emitting green light. Each of the R, G, and B subpixel areas RPA, GPA, and BPA may be represented by a first type subpixel, a second type subpixel, and a third type subpixel.

The blue B subpixel area BPA may include a first lens region BWE including a first light emitting area BE1 of a first light emitting device EL1 and a first lens LZ1 disposed to overlap the first light emitting area BE1, and a second lens region BNE including a second lens LZ2 disposed to overlap a second light emitting area BE2 of a second light emitting device EL2.

The red R subpixel area RPA may include a first lens region RWE including a first light emitting area RE1 of the first light emitting device EL1 and a first lens LZ1 disposed to overlap the first light emitting area RE1, and a second lens region RNE including a second light emitting area RE2 of the second light emitting device EL2 and a second lens LZ2 disposed to overlap the second light emitting area RE2.

The green G subpixel area GPA may include a first lens region GWE including a first light emitting area GE1 of the first light emitting device EL1 and a first lens LZ1 disposed to overlap the first light emitting area GE1, and a second lens region GNE including a second light emitting area GE2 of the second light emitting device EL2 and a second lens LZ2 disposed to overlap the second light emitting area GE2.

As described above with reference to FIGs. 4A and 4B, the first lens LZ1 and the second lens LZ2 may control the viewing angle differently in the horizontal direction X and may control the viewing angle identically in the vertical direction Y.

Each of the first lens regions BWE, RWE, and GWE of the pixel area PA may include one first light emitting area BE1, RE1, and GE1, and one first lens L1 and Z1. Each of the second lens regions PNE, RNE, and GNE of the pixel area PA may include a plurality of second light emitting areas BE2, RE2, and GE2, and a plurality of second lenses LZ2.

Each of the first light emitting areas BE1, RE1, and GE1 included in the first lens region BWE, RWE, and GWE of each pixel area PA may have a shape which is the same as or similar to that of a lower surface of the first lens LZ1. The size of the first lens LZ1 is larger than the size of each of the first light emitting areas BE1, RE1, and GE1, to thereby improve an emission efficiency of light generated in each of the first light emitting areas BE1, RE1, and GE1.

Each of the second light emitting areas BE2, RE2, and GE2 included in the second lens region BNE, RNE, and GNE of each pixel area PA may have a shape which is the same as or similar to that of a lower surface of the second lens LZ2. The size of the second lens LZ2 is larger than the size of each of the second light emitting areas BE2, RE2, and GE2, to thereby improve an emission efficiency of light generated in each of the second light emitting areas BE2, RE2, and GE2.

According to one example of the present disclosure, the second light emitting areas BE2, RE2, and GE2 included in the second lens region PNE, RNE, and GNE of each pixel area PA may have the same size area, and the number of second light emitting areas BE2, RE2, and GE2 may be different for each subpixel area RPA, GPA, and BPA. For example, the number of the second light emitting areas BE2 disposed in the second lens region BNE of the blue B subpixel area BPA may be greater than the number of second light emitting areas RE2 disposed in the second lens region RNE of the red R subpixel area RPA and may be greater than the number of second light emitting areas GE2 disposed in the second lens region GNE of the green G subpixel area GPA. The number of second light emitting areas GE2 disposed in the second lens region GNE of the green G subpixel area GPA may be greater than the number of second light emitting areas RE2 disposed in the second lens region RNE of the red R subpixel area RPA. Accordingly, an efficiency deviation of the second red R, green G, and blue B light emitting devices in each pixel area PA may be supplemented by the number of second light emitting areas BE2, RE2, and GE2 disposed in the second lens region BNE, RNE, and GNE of each pixel area PA.

In the example of the present disclosure, the sizes of the first light emitting areas BE1, RE1, and GE1 may be different for each subpixel area RPA, GPA, and BPA. For example, the size of the first light emitting area BE1 of the blue B subpixel area BPA may be greater than the size of the first light emitting area RE1 of the red R subpixel area RPA and may be larger than the size of the first light emitting area GE1 of the green G subpixel area GPA. The size of the first light emitting area GE1 of the green G subpixel area GPA may be larger than the size of the first light emitting area RE1 of the red R subpixel area RPA. Accordingly, an efficiency deviation of the first red R, green G, and blue B light emitting devices in each pixel area PA may be supplemented by the size of the first light emitting areas BE1, RE1, and GE1 disposed in the first lens region BWE, RWE, and GWE of each pixel area PA.

According to one example of the present disclosure, as shown in FIGs. 6 and 7, the display panel 100 comprises a circuit device layer including a substrate 101 and transistors ET1 and ET2 disposed on the substrate 101, a light emitting device layer including the light emitting devices EL1 and EL2 disposed on the circuit device layer, an encapsulation layer 800 disposed on the light emitting device layer, and a lens layer including the lenses LZ1 and LZ2 disposed on the encapsulation layer 800. The display panel 100 according to one example of the present disclosure may further include a touch sensor layer (not shown) disposed between the encapsulation layer 800 and the lens layer. The display panel 100 according to one example of the present disclosure may further include a color filter layer (not shown) including a black matrix and a color filter disposed between the touch sensor layer and the lens layer.

Referring to FIGs. 6 and 7, a cross-sectional structure of the blue B subpixel area BPA among the red R, green G, and blue B subpixel areas RPA, GPA, and BPA in the display panel according to one example of the present disclosure will be described. The red R, green G, and blue B subpixel areas RPA, GPA, and BPA may have the same cross-sectional structure.

Each subpixel area BPA of the display panel according to one example of the present disclosure may include the first lens region BWE shown in FIG. 6 and the second lens region BNE shown in FIG. 7.

Referring to FIG. 6, the first lens region BWE of the subpixel area BPA may include the first mode control transistor ET1 of the pixel circuit, the first light emitting device EL1 connected to the first mode control transistor ET1, and the first lens LZ1 disposed to overlap the first light emitting area BE1 on the first light emitting device EL1.

Referring to FIG. 7, the second lens region BNE of the subpixel area BPA may include the second mode control transistor ET2 of the pixel circuit, the second light emitting device EL2 connected to the second mode control transistor ET2, and the plurality of second lenses LZ2 disposed to overlap the plurality of second light emitting areas BE2 on the second light emitting device EL2.

In the display panel according to one example of the present disclosure, the circuit device layer disposed on the substrate 101 include a plurality of insulating layers stacked on the substrate 10. For example, the plurality of insulating layers may include a buffer layer 110, a gate insulating layer 120, an insulating interlayer 130, a protective layer 140, and a planarization layer 150.

The substrate 101 may include an insulating material such as glass or plastic. The plastic substrate may be formed of a flexible material. For example, the substrate 101 may include at least one organic insulating material among acrylic resin, epoxy-based resin, siloxane-based resin, polyimide-based resin, and polyamide-based resin.

The buffer layer 110 may have a single-layered or multi-layered structure including an inorganic insulating material such as silicon oxide SiOx, silicon nitride SiNx, and aluminum oxide Al₂O₃. The buffer layer 110 may prevent impurities such as hydrogen from flowing into semiconductor layers 211 and 221 through the substrate 101.

The transistors ET1 and ET2 may be disposed on the buffer layer 110.

The first mode control transistor ET1 includes the semiconductor layer 211, a gate electrode 213, a source electrode 215, and a drain electrode 217 disposed on the buffer layer 110. The second mode control transistor ET2 includes the semiconductor layer 221, a gate electrode 223, a source electrode 225, and a drain electrode 227 disposed on the buffer layer 110. The gate insulating layer 120 is disposed between the semiconductor layers 211 and 221 and the gate electrodes 213 and 223. The insulating interlayer 130 is disposed between the gate electrodes 213 and 223 and the source and drain electrodes 215, 217, 225, and 227. The source electrode 215 and the drain electrode 217 of the first mode control transistor ET1 may be connected to source and drain regions of the semiconductor layer 211, respectively, through contact holes passing through the insulating interlayer 130 and the gate insulating layer 120. The source electrode 225 and the drain electrode 227 of the second mode control transistor ET2 may be connected to source and drain regions of the semiconductor layer 221, respectively, through contact holes passing through the insulating interlayer 130 and the gate insulating layer 120.

The semiconductor layers 211 and 221 may include polycrystalline silicon or may include an oxidation semiconductor material. The semiconductor layers 211 and 221 may include low temperature polysilicon LPTS. The semiconductor layers 211 and 221 may include at least one oxide semiconductor material selected from the group consisting of IZO(InZnO)-based, IGO(InGaO)-based, ITO(InSnO)-based, IGZO(InGaZnO)-based, IGZTO(InGaZnSnO)-based, GZTO(GaZnSnO)-based, GZO(GaZnO)-based, and ITZO(InSnZnO)-based materials. A light shielding layer (not shown) may be further disposed under the semiconductor layers 211 and 221.

The gate insulating layer 120 may include an inorganic insulating material such as silicon oxide SiOx and silicon nitride SiNx. The gate insulating layer 120 may include a material having a high dielectric constant. For example, the gate insulating layer 120 may include a High-K material such as hafnium oxide HfO. The gate insulating layer 120 may have a multi-layered structure.

Then, gate lines (not shown) connected to the gate electrodes 213 and 223 may be disposed on the gate insulating layer 120.

The insulating interlayer 130 may include an inorganic insulating material such as silicon oxide SiOx and silicon nitride SiNx. The insulating interlayer 130 may have a multi-layered structure.

Also, data lines (not shown) and power lines (not shown) connected to the source electrodes 215 and 225 or drain electrodes 217 and 227 may be disposed on the insulating interlayer 130.

The protective layer 140 and the planarization layer 150 may be stacked on the first and second mode control transistors ET1 and ET2. The protective layer 140 may include an inorganic insulating material such as silicon oxide SiOx and silicon nitride SiNx. The planarization layer 150 may include an organic insulating material which is different from that of the protective layer 140 and may provide a flat surface.

The light emitting device layer including the first light emitting device EL1 and the second light emitting device EL2 may be disposed on the planarization layer 150.

The first light emitting device EL1 includes a first electrode 311 disposed on the planarization layer 150, a light emitting layer 312 disposed on the first electrode 311, and a second electrode 313 disposed on the light emitting layer 312. The second light emitting device EL2 includes a first electrode 321 disposed on the planarization layer 150, a light emitting layer 322 disposed on the first electrode 321, and a second electrode 323 disposed on the light emitting layer 322. The first light emitting device EL1 and the second light emitting device EL2 disposed in each subpixel area BPA may emit light of the same color.

The first electrode 311 of the first light emitting device EL1 may be connected to any one of the source electrode 215 and the drain electrode 217 of the first mode control transistor ET1 through a contact hole passing through the planarization layer 150 and the protective layer 140. The first electrode 321 of the second light emitting device EL2 may be connected to any one of the source electrode 225 and the drain electrode 227 of the second mode control transistor ET2 through a contact hole passing through the planarization layer 150 and the protective layer 140.

The first electrodes 311 and 321 may include a conductive material having high reflectance. The first electrodes 311 and 321 may include a metal material such as aluminum Al, silver Ag, titanium Ti, and a silver-palladium-copper APC alloy. The first electrodes 311 and 321 may further include a transparent conductive material such as Indium Tin Oxide ITO or Indium Zinc Oxide IZO. For example, the first electrodes 311 and 321 may have a multilayer structure Ti/Al/Ti of titanium Ti and aluminum Al, a multilayer structure ITO/Al/ITO of ITO and aluminum Al, or a multilayer structure ITO/APC/ITO of ITO and APC.

The light emitting layers 312 and 322 may include an emission material layer EML including a light emitting material. The light emitting material may include an organic material, an inorganic material, or a hybrid material. The light emitting layer 312 of the first light emitting device EL1 may be spaced apart from the light emitting layer 322 of the second light emitting device EL2. Accordingly, it is possible to prevent a light emission caused by a leakage current.

The light emitting layers 312 and 322 may have a multilayer structure. For example, the light emitting layers 312 and 322 may further include at least one of a hole injection layer HIL, a hole transport layer HTL, an electron transport layer ETL, and an electron injection layer EIL.

The second electrodes 313 and 323 may include a conductive material capable of transmitting light therethrough. The second electrodes 313 and 323 may include a transparent conductive material such as ITO or IZO. The second electrodes 313 and 323 may include aluminum Al, magnesium Mg, silver Ag, or an alloy thereof, and may have a small thickness (thin profile) capable of transmitting light. Accordingly, light generated in each of the light emitting layers 312 and 322 may be emitted through each of the second electrodes 313 and 323.

The first electrode 311 of the first light emitting device EL1 is spaced apart from the first electrode 321 of the second light emitting device EL2, and a bank insulating layer 160 may be positioned between the first electrodes 311 and 321. The bank insulating layer 160 may cover the edge of each of the first electrodes 311 and 321. The bank insulating layer 160 may include an organic insulating material. The bank insulating layer 160 may include an organic material which is different from that of the planarization layer 150 and may have a single-layer or double-layer structure.

The bank insulating layer 160 may include an opening through which the first electrode 311 is exposed, to thereby define the first light emitting area BE1. The light emitting layer 312 and the second electrode 313 of the first light emitting device EL1 may be stacked on the first electrode 311 exposed by the opening of the bank insulating layer 160.

The bank insulating layer 160 may include an opening through which the first electrode 321 of the second light emitting device EL2 is exposed, to thereby define the second light emitting area BE2. In one example of the present disclosure, the bank insulating layer 160 includes a plurality of openings on the first electrode 321 of the second light emitting device EL2, to thereby define the plurality of second light emitting areas BE2. The light emitting layer 322 and the second electrode 323 of the second light emitting device EL2 may be stacked on the first electrode 321 exposed by the opening of the bank insulating layer 160. The light emitting layer 322 and the second electrode 323 of the second light emitting device EL2 may overlap the first electrode 321 with the bank insulating layer 160 interposed therebetween. In the second lens region BNE, even though the plurality of second light emitting areas BE2 are spaced apart from each other and are independently disposed by the bank insulating layer 160, the first electrode 321 of the second light emitting device EL2 may be shared, the light emitting layer 322 of the second light emitting device EL2 may be shared, and the second electrode 323 of the second light emitting device EL2 may be shared therein. Accordingly, an emission efficiency of the second light emitting areas BE2 may be improved. The size of the second light emitting area BE2 may be smaller than the size of the first light emitting area BE1.

The second electrode 313 of the first light emitting device EL1 may be a common electrode electrically connected to the second electrode 323 of the second light emitting device EL2.

The encapsulation layer 800 may be disposed on the light emitting device layer including the first light emitting device EL1 and the second light emitting device EL2 of each subpixel area BPA. The encapsulation layer 800 may prevent the light emitting devices EL1 and EL2 from being damaged by external moisture or shock. The encapsulation layer 800 may have a multilayer structure. For example, the encapsulation layer 800 may include a first encapsulation layer 810, a second encapsulation layer 820, and a third encapsulation layer 830 which are sequentially stacked, and examples of the present disclosure are not limited thereto. The first encapsulation layer 810, the second encapsulation layer 820, and the third encapsulation layer 830 may include an insulating material. The second encapsulation layer 820 may include a material different from those of the first encapsulation layer 810 and the third encapsulation layer 830. For example, the first encapsulation layer 810 and the third encapsulation layer 830 may be inorganic encapsulation layers including an inorganic insulating material, and the second encapsulation layer 820 may be an organic encapsulation layer including an organic insulating material. Accordingly, it is possible to prevent the light emitting devices EL1 and EL20 of the display apparatus from being damaged by an external moisture or shock.

The lens layer including the first lens LZ1 and the second lens LZ2 may be disposed on the encapsulation layer 800 of each subpixel area BPA.

The first lens LZ1 is disposed on the first light emitting area BE1 of the first light emitting device 310 in the first lens region BWE so that the traveling path of light generated in the first light emitting area BE1 is not limited in the left-and-right direction, that is, it is controlled to be the wide viewing angle. For example, the first lens LZ1 does not limit the traveling path of light emitted from the first light emitting area BE1 of the first light emitting device EL1 to be within a specific angle in the left-and-right direction, whereby it is controlled to be the wide viewing angle. Also, the first lens LZ1 limits the traveling path of light emitted from the first light emitting area BE1 of the first light emitting device EL1 to be within a specific angle in the up-and-down direction, whereby it is controlled to be the narrow viewing angle.

The second lens LZ2 is disposed on the second light emitting area BE2 of the second light emitting device EL2 in the second lens region BNE so that the traveling path of light generated in the second light emitting area BE2 is limited in the left-and-right direction, that is, it is controlled to be the narrow viewing angle. For example, the second lens LZ2 limits the traveling path of light emitted from the second light emitting area BE2 of the second light emitting device EL2 to be within a specific angle in the left-and-right direction, whereby it is controlled to be the narrow viewing angle. Also, the second lens LZ2 limits the traveling path of light emitted from the second light emitting area BE2 of the second light emitting device EL2 to be within a specific angle in the up-and-down direction, whereby it is controlled to be the narrow viewing angle.

A lens protection layer 600 may be disposed on the first lens LZ1 and the second lens LZ2 of each subpixel area BPA. The lens protection layer 600 may include an organic insulating material. A refractive index of the lens protection layer 600 may be smaller than a refractive index of the first lens LZ1 and a refractive index of the second lens LZ2. Accordingly, light passing through the first lens LZ1 and the second lens LZ2 may not be reflected toward the substrate 101 due to a difference in refractive index to the lens protection layer 600.

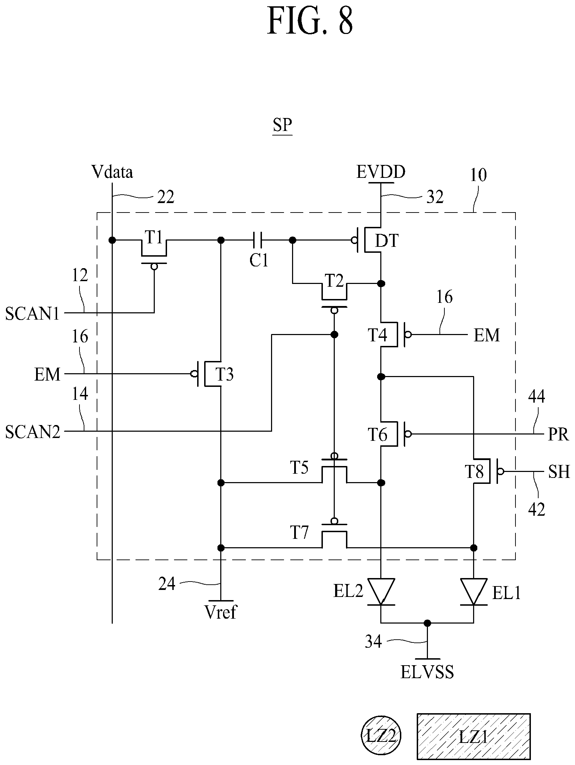

FIG. 8 is an equivalent circuit diagram illustrating a circuit configuration of each subpixel in the display panel according to one example of the present disclosure.

Referring to FIG. 8, each of the subpixels SP may include a pixel circuit 10 including a plurality of transistors DT and T1 to T8 and first and second light emitting devices EL1 and EL2, and first and second lenses LZ1 and LZ2 disposed on the first and second light emitting devices EL1 and EL2, respectively.

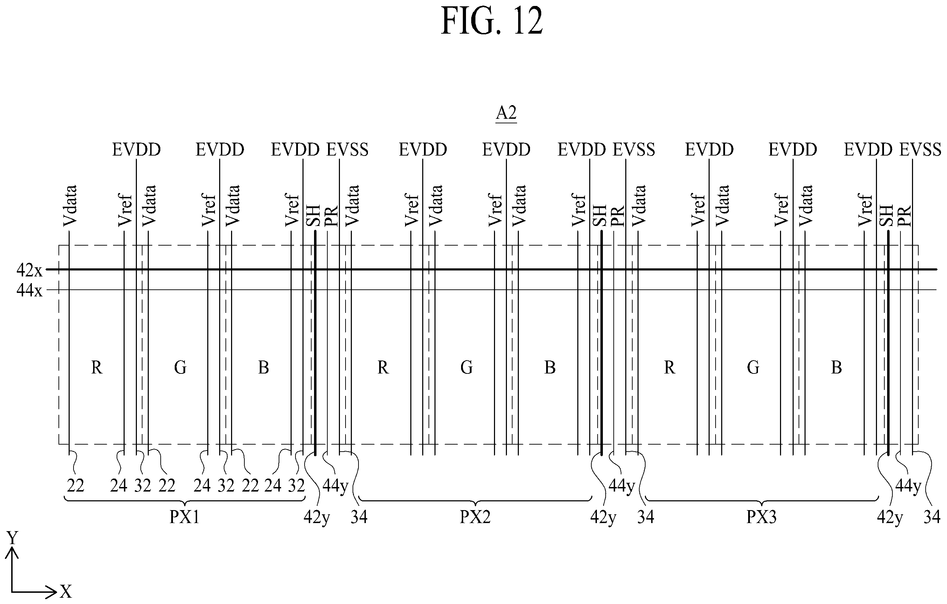

The pixel circuit 10 of the subpixel SP shown in FIG. 12 may include eight switching transistors T1 to T8, a driving transistor DT, a storage capacitor Cst, and first and second light emitting devices EL1 and EL2, but not limited to this configuration. In FIG. 12, the first mode control transistor T8 may correspond to the first mode control transistor ET1 shown in FIG. 6, and the second mode control transistor T6 may correspond to the second mode control transistor ET2 shown in FIG. 7.

The pixel circuit 30 of each subpixel SP may be driven to include an initial period, a sampling period, a program period, and an emission period for each frame period.

In each subpixel SP, the first light emitting device EL1 is driven by the first mode control transistor T8 controlled by the first mode control signal SH, and the second light emitting device EL2 may be driven by the second mode control transistor T6 controlled by the second mode control signal PR. The first lens LZ1 disposed in the light traveling direction of the first light emitting device EL1 may control the viewing angle in the left-and-right direction to the wide viewing angle. The second lens LZ2 disposed in the light traveling direction of the second light emitting device EL2 may control the viewing angle in the left-and-right direction to the narrow viewing angle.

Each transistor DT and T1 to T8 in each subpixel SP includes a gate electrode, a source electrode, and a drain electrode. Since the source electrode and the drain electrode may be changed according to a voltage and a current direction applied to the gate electrode without being fixed, any one of the source electrode and the drain electrode may be represented as a first electrode, and the other may be represented as a second electrode. The transistors DT and T1 to T8 of each subpixel SP may use at least one of polysilicon semiconductor, amorphous silicon semiconductor, and oxide semiconductor. The transistors may be P-type or N-type, or P-type and N-type may be used interchangeably.

Each of the light emitting devices EL1 and EL2 may include an anode electrode individually connected to the switching transistors T8 and T6, a cathode electrode supplied with the second power supply voltage EVSS (low potential power voltage) from the second power line 34, and a light emitting layer between the anode electrode and the cathode electrode. The anode electrode is an independent electrode for each light emitting device, but the cathode electrode may be a common electrode shared by the entire light emitting devices. When a driving current is supplied from the driving transistor DT through each of the mode control transistors T8 and T6, electrons from the cathode electrode are injected into the light emitting layer, and holes from the anode electrode are injected into the organic light emitting layer, whereby a fluorescent or phosphorescent material emit light through recombination of the electrons and holes in the light emitting layer, thereby generating light of brightness proportional to a current value of the driving current.

The first electrode of the driving transistor DT may be connected to the first power line 17 for supplying the first power supply voltage EVDD. The first power supply voltage EVDD may be supplied from the power management circuit 700. The second electrode of the driving transistor DT may be commonly connected to the first electrodes of the first and second mode control transistors T8 and T7 through the fourth switching transistor T4. The driving transistor DT drives the first light emitting device EL1 through the fourth switching transistor T4 and the first mode control transistor T8 or drives the second light emitting device EL2 through the fourth switching transistor T4 and the second mode control transistor T6. The driving transistor DT controls the driving current Ids according to the driving voltage Vgs of the storage capacitor C1 so that it is possible to control the emission intensity of the first light emitting device EL1 or the second light emitting device EL2 through the first mode control transistor T8 or the second mode control transistor T6.

The storage capacitor C1 is connected between the gate electrode of the driving transistor DT and the first electrode, whereby the storage capacitor C1 may be charged with the driving voltage Vgs corresponding to the data voltage Vdata. The storage capacitor C1 may hold the charged driving voltage Vgs during the emission period in which the first switching transistor T1 is turned-off, and may supply the held driving voltage Vgs to the driving transistor DT.

The first switching transistor T1 may be turned-on or turned-off in response to a first scan signal SCAN1 supplied to the first gate line 12 disposed in the (N)th pixel row line ('N' is a natural number). The first switching transistor T1 may supply the data voltage Vdata supplied through the data line 22 to the first electrode of the storage capacitor Cst during the sampling and program period in response to the first scan signal SCAN1. The first scan signal SCAN1 may be supplied from the scan driver 210, (FIG. 1).

The second, fifth, and seventh switching transistors T2, T5, and T7 may be turned-on or turned-off in response to a second scan signal SCAN2 supplied to the second gate line 14 disposed in the (N)th pixel row line. The second scan signal SCAN2 may be supplied from the scan driver 210 (FIG. 1).

The second switching transistor T2 connects the gate electrode of the driving transistor DT and the second electrode (or drain electrode) to each other during the initialization period and the sampling and programming period in response to the second scan signal SCAN2, thereby connecting the driving transistor DT in a diode structure. The second switching transistor T2 may charge and compensate a threshold voltage Vth of the driving transistor DT in the storage capacitor C1. Accordingly, the storage capacitor C1 may charge the data voltage (Vdata + Vth) in which the threshold voltage Vth of the driving transistor DT is compensated during the sampling and programming period.

The fifth switching transistor T5 may supply the initialization voltage Vref (or reference voltage) supplied through the initialization voltage line 24 to the anode electrode of the second light emitting device EL2 during the initialization period, the sampling period, and the program period in response to the second scan signal SCAN2.

The seventh switching transistor T7 may supply an initialization voltage Vref (or reference voltage) supplied through the initialization voltage line 24 to the anode electrode of the first light emitting device EL1 during the initialization period, the sampling period, and the program period in response to the second scan signal SCAN2.

The third and fourth switching transistors T3 and T4 may be turned-on or turned-off in response to the emission control signal EM supplied to the third gate line 16 disposed in the (N)th pixel row line. The emission control signal EM may be supplied from the emission control driver 220 (FIG. 1).

The third switching transistor T3 may supply the initialization voltage Vref (or reference voltage) supplied through the initialization voltage line 24 to the first electrode of the storage capacitor Cst during the initialization period and the emission period in response to the emission control signal EM.

The fourth switching transistor T 4 may connect the driving transistor DT and the first and second mode control transistors T1 and T2 during the initialization period and the emission period in response to the emission control signal EM.

The first mode control transistor T8 may be turned-on or turned-off under the control of the first mode control signal SH, and the second mode control transistor T6 may be turned-on or turned-off under the control of the second mode control signal PR.

When it is the share mode or wide viewing angle mode in which the first mode control signal SH is activated, the first mode control transistor T8 may connect the driving transistor DT and the first light emitting device EL1 during the emission period in which the fourth switching transistor T4 is turned-on by the emission control signal EM. Accordingly, the first light emitting device EL1 is driven by the driving current from the driving transistor DT and is configured to emit light so that the subpixel SP may emit light at the wide viewing angle through the first lens LZ1.

When the second mode control signal PR is the privacy mode or narrow viewing angle mode, the second mode control transistor T6 may connect the driving transistor DT and the second light emitting device EL2 during the emission period in which the fourth switching transistor T4 is turned-on by the emission control signal EM. Accordingly, the second light emitting device EL2 is driven by the driving current from the driving transistor DT and is configured to emit light so that the subpixel SP emits light at the narrow viewing angle through the second lens LZ2.

The first and second mode control signals SH and PR may be supplied from the data driver 300 or mode controller (not shown). When each subpixel SP is operated in the wide viewing angle mode, the first mode control signal SH may be activated to a gate-on voltage, and the second mode control signal PR may be deactivated to a gate-off voltage. When each subpixel SP is operated in the narrow viewing angle mode, the first mode control signal SH is deactivated to the gate-off voltage, and the second mode control signal PR may be activated to the gate-on voltage.

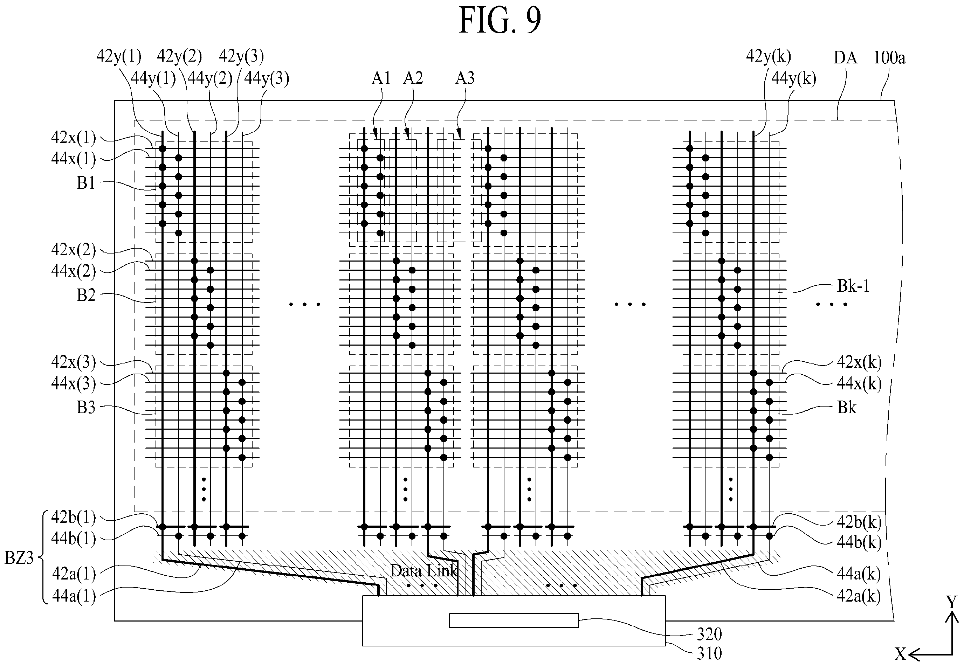

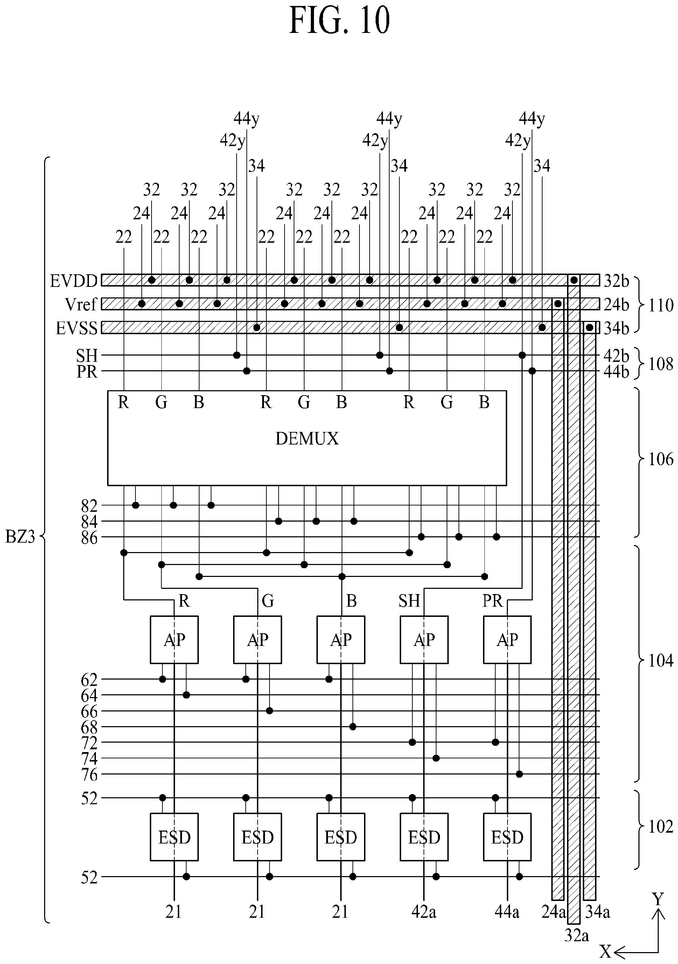

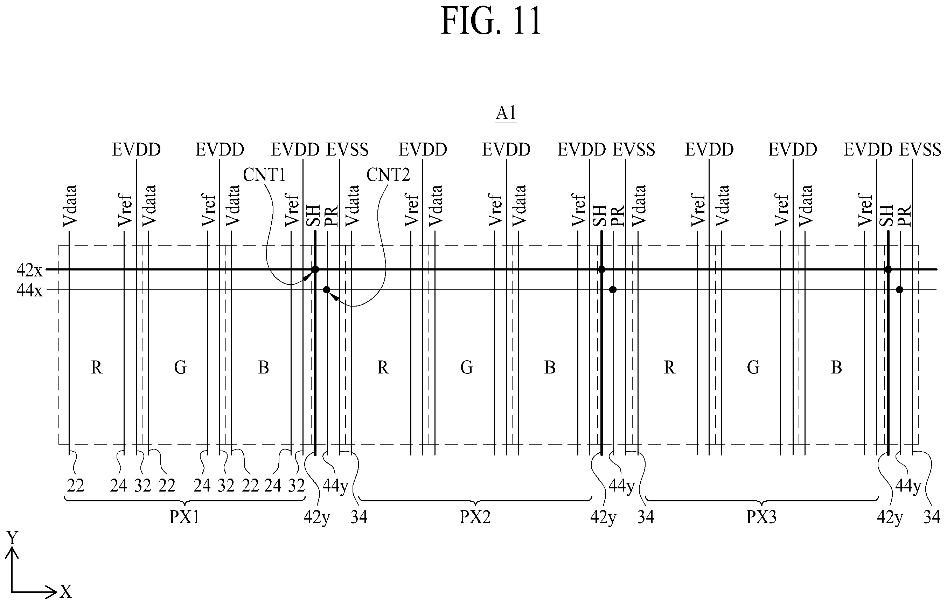

FIG. 9 is a diagram illustrating a schematic layout structure of first and second mode control lines in a portion of a display panel according to one example of the present disclosure, and FIG. 10 is a diagram illustrating a schematic layout structure of a bezel area illustrated in FIG. 9. FIG. 11 is a diagram illustrating a schematic layout structure of first and second mode control lines in a portion of a display panel according to one example of the present disclosure, and FIG. 12 is a diagram illustrating a schematic layout structure of a bezel area illustrated in FIG. 11.

Referring to FIGs. 9 and 11, a display apparatus according to one example of the present disclosure schematically illustrates an arrangement structure of a COF 310 on which one of a plurality of data drive ICs 320 is mounted, and first and second mode control lines 42 and 44 in a portion of a display panel 100a and 100b driven by the data drive IC 320.

The first mode control line 42(n) (n= 1, 2, 3, ..., k) for supplying a first mode control signal SH may include first and second types of first mode control lines 42x(n) and 42y(n) (n= 1, 2, 3, ..., k) disposed in a display area DA and third and fourth types of first mode control lines 42a(n), 42b(n), 42a(n), and 42b(n) (n= 1, 2, 3, ..., k) disposed in a bezel area BZ3. The second mode control line 44(n) (n= 1, 2, 3, ..., k) for supplying the second mode control signal PR may include first and second types of second mode control lines 44x(n) and 44y(n) (n= 1, 2, 3, ..., k) disposed in the display area DA and third and fourth types of second mode control lines 44a(n), 44b(n), 44a(n), and 44b(n) (n= 1, 2, 3, ..., k) disposed in the bezel area BZ3.

The third type of mode control lines 42a(n) and 44a(n) and the fourth type of mode control lines 42b(n) and 44b(n) may be disposed in a data link area between the COF 310 and the display area DA in the third bezel area BZ3 on which the COF 310 is disposed. The third type of mode control lines 42a(n) and 44a(n) may be connected to the mode controller (not shown) disposed on the data drive IC 320 or printed circuit board PCB (not shown) via the COF 310. The fourth type of mode control lines 42b(n) and 44b(n) may be disposed at the first direction X in the third bezel area BZ3 and may be individually connected to the mode control lines 42a(n) and 44a(n) of the third type.

Referring to FIG. 9, in the third bezel area BZ3, the mode control lines 42a(n) and 44a(n) of the third type may be disposed in the data link area, and the mode control lines 42b(n) and 44b(n) of the fourth type may be separately disposed in the first direction X. For example, the mode control lines 42b(1) and 44b(1) of the fourth type of the first set may be arranged in parallel in the first direction X while being separated in the first direction from the mode control lines 42b(2) and 44b(2) of the fourth type of the second set adjacent in the first direction X. Accordingly, it is possible to minimize the increase of the third bezel area BZ3 by the mode control lines 42a(n) and 44a(n) of the third type and the mode control lines 42b(n) and 44b(n) of the fourth type.

Referring to FIG. 11, in the third bezel area BZ3, the mode control lines 42a(n) and 44a(n) of the third type may be disposed outside the data link area, and the mode control lines 42b(n) and 44b(n) of the fourth type may be disposed in parallel in the second direction Y. For example, the mode control lines 42b(1) and 44b(1) of the fourth type of the first set, the mode control lines 42b(2) and 44b(2) of the fourth type of the second set, and the mode control lines 42b(i) and 44b(i) of the fourth type of the (i)th set may be arranged in parallel in the second direction Y. The mode control lines 42b(i+1) and 44b(i+1) of the fourth type of the (i+1)th set to the mode control lines 42b(k) and 44b(k) of the fourth type of the (k)th set may be arranged in parallel in the second direction Y and may be separated from the first to (i)th sets in the first direction X. Accordingly, it is possible to minimize the interference between the mode control lines 42a(n) and 44a(n) of the third type and the data link area.

The mode control lines 42y(n) and 44y(n) of the second type disposed at the second direction Y in the display area DA may be individually connected to the mode control lines 42b(n) and 44b(n)) of the bezel area BZ3. The mode control lines 42x(n) and 44x(n) of the first type disposed at the first direction X in the display area DA may be connected to the subpixels and may be individually connected to the mode control lines 42y(n) and 44y(n) of the second type in the second direction Y.

The display area DA of the display panel 100a and 100b according to one example of the present disclosure may include a plurality of pixel blocks B1~Bk capable of independently controlling the viewing angle. Each of the plurality of pixel blocks B1~Bk may be driven in the independent viewing angle mode by each of the plurality of mode control sets including the mode control lines 42x(1) to 42x(k), 42y(1) to 42y(k), 44x(1) to 44x(k), and 44y(1) to 44y(k).

For example, the first pixel block B 1 may be connected to the first mode control set 42(1) and 44(1) including the (1-1)th mode control line 42(1): 42a(1), 42b(1), 42y(1), and 42x(1) and the (2-1)th mode control line 44(1): 44a(1), 44b(1), 44y(1), and 44x(1) and may be driven in the wide viewing angle mode or narrow viewing angle mode by the first mode control set 42(1) and 44(1). The second pixel block B2 may be connected to the second mode control set 42(2) and 44(2) including the (1-2)th mode control line 42(2): 42a(2), 42b(2), 42y(2), and 42x(2) and the (2-2)th mode control line 44(2): 44a(2), 44b(2), 44y(2), and 44x(2) and may be driven in the wide viewing angle mode or narrow viewing angle mode by the second mode control set 42(2) and 44(2). Similarly, the (k)th pixel block Bk may be connected to the (k)th mode control set 42(k) and 44(k) including the (1-k)th mode control line 42(k): 42a(k), 42b(k), 42y(k), and 42x(k) and the (2-k)th mode control line 44(k): 44a(k), 44b(k), 44y(k), and 44x(k) and may be driven in the wide viewing angle mode or narrow viewing angle mode by the (k)th mode control set 42(k) and 44(k).

The mode control lines 42y(n) and 44y(n) of the second type disposed at the second direction Y in each of the pixel blocks B1~Bk may extend to other pixel blocks disposed in the same column at the second direction Y, whereby they may have the similar length in the display area DA.

In the first type pixel area A1 of the corresponding pixel block, the mode control lines 42y(n) and 44y(n) of the second type in the second direction Y may be connected to the mode control lines 42x(n) and 44x(n) of the first type in the first direction X through the contact holes of the insulating layer and may intersect the mode control lines 42x(n) and 44x(n) of the first type in the first direction X with the insulating layer therebetween.

In the second type pixel area A2 of the other pixel block, the mode control lines 42y(n) and 44y(n) of the second type in the second direction Y may be configured to intersect the mode control lines of the first type in the first direction X while being not connected to the mode control lines of the first type in the first direction X with the insulating layer therebetween.

The mode control lines 42x(n) and 44x(n) of the first type in the first direction X disposed in each of the plurality of pixel blocks B1~Bk may be disconnected from the mode control lines of the first type of the other pixel block adjacent in the first direction X, in the same manner as the third type pixel area A3.

Referring to FIGs. 10 and 12, in the display panel 100a and 100b according to one example of the present disclosure, the third bezel area BZ3 may include an electrostatic prevention circuit ESD region 102, a lighting test circuit AP region 104, a demultiplexer circuit DEMUX region 106, a mode control line region 108 and 118, and a power line region 110, which are disposed in the second direction Y between the pad area in which the COF 320 is disposed and the display area DA.

In the electrostatic prevention circuit ESD region 102 and the lighting test circuit AP region 104, a plurality of data input lines 21, first and second mode control lines 42a and 44a, and power input lines 24a, 32a, and 34a may be disposed in parallel in the first direction X and may extend in the second direction Y.

An electrostatic prevention circuit ESD including a plurality of transistors may be connected to each of the first and second mode control lines 42a and 44a of the third type and the plurality of data input lines 21 disposed in the electrostatic prevention circuit ESD region 102. Each of the electrostatic prevention circuits ESD is operated when static electricity is introduced through any one of the plurality of data input lines 21 and the first and second mode control lines 42a and 44a of the third type and is configured to discharge static electricity through an electrostatic discharge line 52.

A lighting test circuit AP including a plurality of transistors may be connected to each of the first and second mode control lines 42a and 44a of the third type and the plurality of data input lines 21 disposed in the lighting test circuit AP region 104. The lighting test circuits AP may be connected to control lines 62 and 72 and test signal supply lines 64, 66, 68, 74, and 76.

A demultiplexer circuit DEMUX disposed in the demultiplexer circuit DEMUX region 106 may distribute and supply data signals R, G, and B supplied through the plurality of data input lines 21 to the data lines 22 whose number is larger than that of the data input lines 21. The demultiplexer circuit DEMUX may include a plurality of transistors connected to the plurality of control lines 82, 84, and 86 and configured to perform a switching operation.

For example, the demultiplexer circuit DEMUX may time-divide the R data signals sequentially supplied through any one of the R data input lines 21 and may sequentially supply the time-divided R data signals to the three of the R data lines 22. The demultiplexer circuit DEMUX time-divides the G data signals sequentially supplied through any one of the G data input line 21 and may sequentially supply the time-divided G data signals to the three of the G data lines 22. The demultiplexer circuit DEMUX time-divides the B data signals sequentially supplied through any one of the B data input line 21 and may sequentially supply the time-divided B data signals to the three of the B data lines 22.

In the demultiplexer circuit DEMUX region 106, the first and second mode control lines 42a and 44A of the third type disposed between the demultiplexer circuit DEMUX and power input lines 24a, 32a, and 34a may extend in the second direction Y.

The first and second mode control lines 42a and 44a of the third type may be respectively connected to the first and second mode control lines 42b and 44b of the fourth type extending in the first direction X in the mode control line regions 108 and 118. The first and second mode control lines 42b and 44b of the fourth type are respectively connected to the first and second mode control lines 42y and 44y of the second type disposed at the second direction Y in the display area DA and are configured to supply the first and second mode control signals SH and PR, respectively.

The number of first and second mode control lines 42b and 44b of the fourth type disposed in the mode control line region 108 shown in FIG. 10 may be smaller than the number of first and second mode control lines 42b and 44b of the fourth type disposed in the mode control line region 118 shown in FIG. 12. Accordingly, the area of the mode control line region 108 shown in FIG. 10 is smaller than the area of the mode control line area 118 shown in FIG. 12 so that it is possible to minimize the increase of the bezel area BZ3.

The power input lines 24a, 32a, and 34a may be respectively connected to power supply lines 24b, 32b, and 34b disposed at the first direction X in the power line region 110. The power supply lines 24b, 32b, and 34b are respectively connected to the power lines 24, 32, and 34 disposed at the second direction Y in the display area DA, and are configured to supply the initialization voltage Vref and the first and second power supply voltages EVDD and EVSS, respectively.

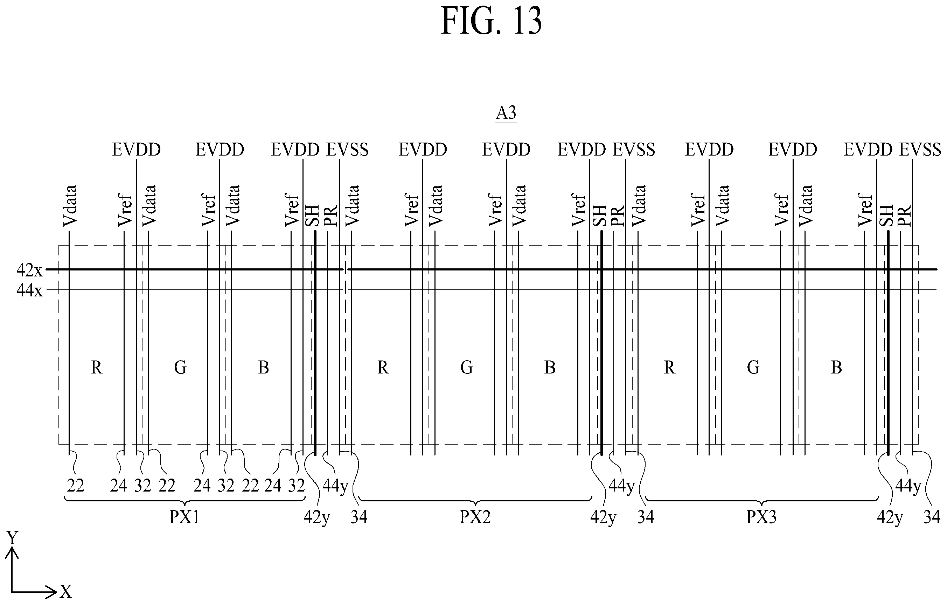

FIGs. 13 to 15 are diagrams illustrating arrangement structures of main signal lines in the first to third type pixel areas A1, A2, and A3 shown in FIGs. 9 and 11.

Referring to FIGs. 13 to 15, each of the pixels PX1, PX2, and PX3 disposed in the pixel areas A1, A2, and A3 of the first to third types may include red, green, and blue subpixels R, G, and B arranged in the first direction X. In each of the red, green, and blue subpixels R, G, and B, the data line 22 for supplying the data voltage Vdata, the initialization voltage line 24 for supplying the initialization voltage Vref, and the first power line 32 for supplying the first power supply voltage EVDD may extend in the second direction Y. The first mode control line 42y of the second type for supplying the first mode control signal SH, the second mode control line 44y of the second type for supplying the second mode control signal PR, and the second power line 34 for supplying the second power supply voltage EVSS may be disposed between each of the pixels PX1, PX2, and PX3.

Referring to FIG. 13, in the first type pixel area A1, the first mode control line 42y of the second type and the second mode control line 44y of the second type disposed in the second direction Y may be connected to the first mode control line 42x of the first type and the second mode control line 44x of the first type disposed in the first direction X, respectively, through contact holes CNT1 and CNT2 of the insulating layer. The first mode control line 42x of the first type and the second mode control line 44x of the first type disposed in the first direction X may be connected to the plurality of subpixels R, G, and B.

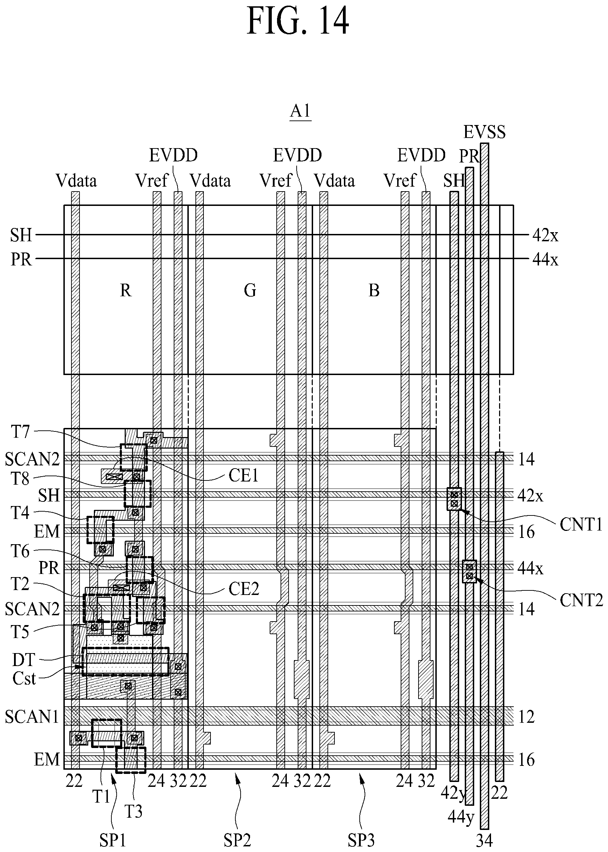

Referring to FIG. 14, in the second type pixel area A2, the first mode control line 42y of the second type and the second mode control line 44y of the second type disposed in the second direction Y may be configured to intersect the first mode control line 42x of the first type and the second mode control line 44x of the first type disposed in the first direction X with at least one insulating layer interposed therebetween while being not connected to the first mode control line 42x of the first type and the second mode control line 44x of the first type disposed in the first direction X.

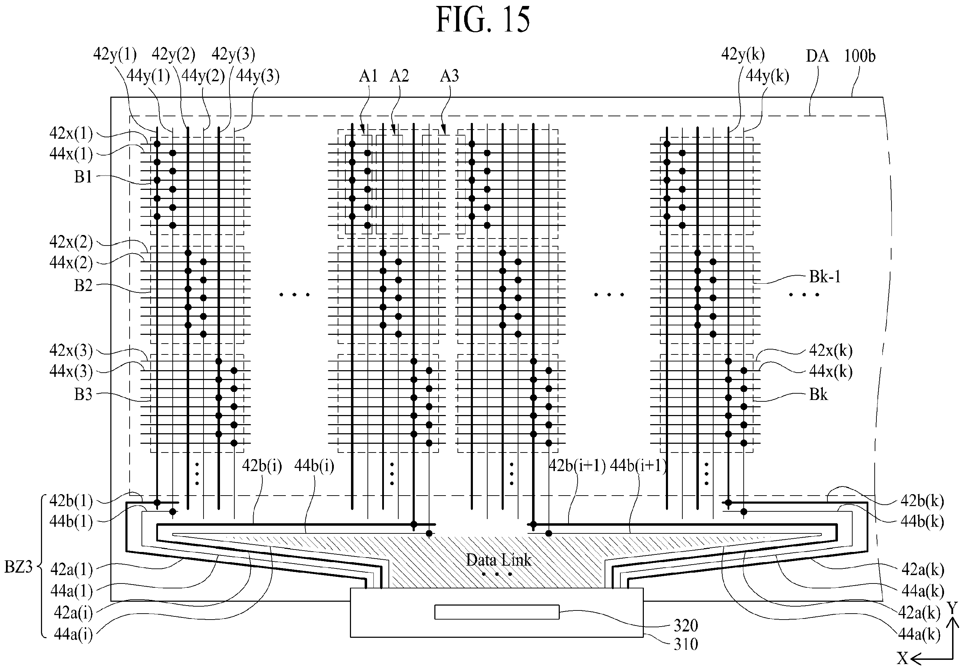

Referring to FIG. 15, in the third type pixel area A3, the first mode control line 42x of the first type and the second mode control line 44x of the first type disposed in the first direction X may be disconnected with respect to the second power line 34 between the first pixel PX1 and the second pixel PX2. The first mode control line 42y of the second type and the second mode control line 44y of the second type disposed in the second direction Y may be configured to intersect the first mode control line 42x of the first type and the second mode control line 44x of the first type disposed in the first direction X with at least one insulating layer interposed therebetween while being not connected to the first mode control line 42x of the first type and the second mode control line 44x of the first type disposed in the first direction X.

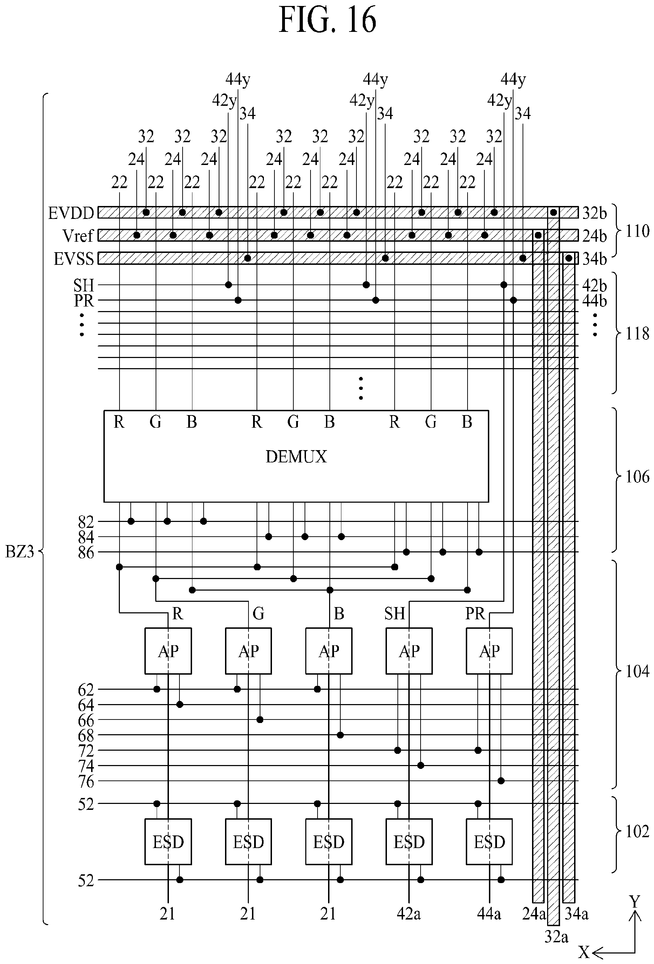

FIG. 16 is a plan view illustrating a pixel arrangement structure in the display panel according to one example of the present disclosure.

Referring to FIG. 16, it exemplarily illustrates an arrangement structure of main signal lines in the first to third subpixels SP1, SP2, and SP3 disposed in the first type pixel area A1 illustrated in FIG. 13 and a planar arrangement structure of the pixel circuit 10 (FIG. 8) of the first subpixel SP1. The second and third subpixels SP2 and SP3 may have the same planar arrangement structure as that of the first subpixel SP1.

Referring to FIGs. 8 and 16, the pixel circuit 10 of the subpixel SP1 may include a driving transistor DT, eight transistors T1 to T8, and a storage capacitor Cst.

The pixel circuit 10 of the subpixel SP1 may include the third gate line 16 and the first gate line 12 arranged in the first direction X at a lower end portion with respect to the driving transistor DT and the storage capacitor ST, and may include the second gate line 14, the second mode control line 44x, the third gate line 16, the first mode control line 42x, and the second gate line 14 arranged in the first direction X at an upper end portion with respect to the driving transistor DT and the storage capacitor ST. The pixel circuit 10 of the subpixel SP1 may include the data line 22, the initialization voltage line 24, and the first power line 32 arranged in the second direction Y.

In the pixel circuit 10 of the subpixel SP1, the third switching transistor T3 may include a semiconductor layer overlapped with the third gate line 16 for supplying the emission control signal EM, a first electrode (source electrode) connected to the initialization voltage line 24 for supplying the initialization voltage Vref, and a second electrode (drain electrode) connected to the first electrode of the storage capacitor Cst.

The first switching transistor T1 may include a semiconductor layer overlapped with the first gate line 12 for supplying the first scan signal SCAN1, a first electrode (source electrode) connected to the data line 22 for supplying the data voltage Vdata, and a second electrode (drain electrode) connected to the first electrode of the storage capacitor Cst.

The driving transistor DT may include a semiconductor layer overlapped with the storage capacitor Cst, a first electrode (source electrode) connected to the first power line 32 for supplying the first power voltage EVDD, and a second electrode (drain electrode) connected to a first electrode (source electrode) of the second switching transistor T2.

The second switching transistor T2 may include a semiconductor layer overlapped with the second gate line 14 for supplying the second scan signal SCAN2, the first electrode (source electrode) connected to the second electrode (drain electrode) of the driving transistor DT, and a second electrode (drain electrode) connected to a second electrode of the storage capacitor Cst.

The fifth switching transistor T5 may include a semiconductor layer overlapped with the second gate line 14 for supplying the second scan signal SCAN2, a first electrode (source electrode) connected to the initialization voltage line 24 for supplying the initialization voltage Vref, and a second electrode (drain electrode) connected to the second electrode (drain electrode) of the second mode control transistor T6 and a second connection electrode CE2. The second connection electrode CE2 may be connected to the anode electrode of the second light emitting device EL2 (FIG. 8).

The second mode control transistor T6 may include a semiconductor layer overlapped with the second mode control line 44x for supplying the second mode control signal PR, a first electrode (source electrode) connected to a second electrode (drain electrode) of the fourth switching transistor T4, and a second electrode (drain electrode) connected to the second contact electrode CE2 connected to the anode electrode of the second light emitting device EL2 (FIG. 8). The first connection electrode CE1 may be connected to the anode electrode of the first light emitting device EL1 (FIG. 8).

The fourth switching transistor T4 may include a semiconductor layer overlapped with the third gate line 16 for supplying the emission control signal EM, a first electrode (source electrode) connected to the second electrode (drain electrode) of the driving transistor DT, and the second electrode (drain electrode) connected to a first electrode (source electrode) of the first mode control transistor T8 and the first electrode (source electrode) of the second mode control transistor T6.

The first mode control transistor T8 may include a semiconductor layer overlapped with the first mode control line 42x for supplying the first mode control signal SH, a first electrode (source electrode) connected to the second electrode (drain electrode) of the fourth switching transistor T4, and a second electrode (drain electrode) connected to the first contact electrode CE1 connected to the anode electrode of the first light emitting device EL1 (FIG. 8).

The seventh switching transistor T7 may include a semiconductor layer overlapped with the second gate line 14 for supplying the second scan signal SCAN2, a first electrode (source electrode) connected to the initialization voltage line 24 for supplying the initialization voltage Vref, and a second electrode (drain electrode) connected to the second electrode (drain electrode) of the first mode control transistor T and the first connection electrode CE1.

The second power line 34 and the first and second mode control lines 42y and 44y of the second type disposed in the second direction Y may be arranged in parallel with the first power line 32 of the third subpixel SP3. Each of the first and second mode control lines 42y and 44y of the second type may be connected to each of the first and second mode control lines 42x and 44x of the first type disposed in the first direction X through the contact holes CNT1 and CNT2 of the insulating layer.

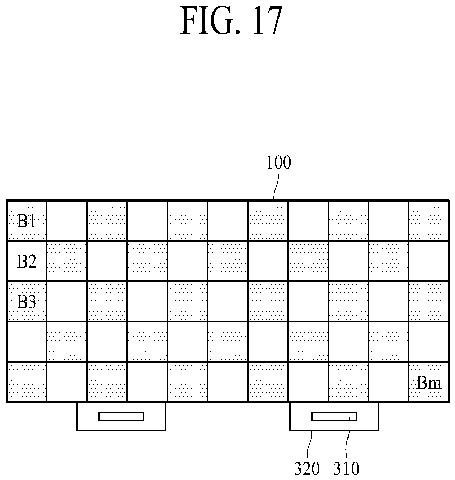

FIG. 17 is a diagram illustrating an arrangement structure of the plurality of pixel blocks in the display apparatus according to one example of the present disclosure.

The display panel 100 according to one example of the present disclosure may be connected to the plurality of COF 320 on which the plurality of data drive IC 310 are respectively mounted. The display area of the display panel 100 may include the plurality of pixel blocks B1~BM capable of independently controlling the viewing angle. Each of the plurality of pixel blocks B1~BM may be independently controlled by the first and second mode control line sets to be selectively controlled in the wide viewing angle mode (share mode) or the narrow viewing angle mode (privacy mode).

As described above, the display panel and the display apparatus according to some examples of the present disclosure selectively drive the first light emitting device corresponding to the first lens region and the second light emitting device corresponding to the second lens region in each subpixel by using the first and second mode control signals so that it is possible to control the viewing angle of each of the plurality of areas in the display area at the wide viewing angle or narrow viewing angle, thereby reducing power consumption.

Also, the display panel and the display apparatus according to some examples of the present disclosure may control each in the plurality of areas at the wide viewing angle or the narrow viewing angle by using the first and second mode control signals so that it is possible to freely adjust the ratio (area) of the wide viewing angle area and the narrow viewing angle area in the first direction and the second direction as well as the position of the wide viewing angle area and the narrow viewing angle area.

Also, the display panel and the display apparatus according to some examples of the present disclosure may improve user's convenience and satisfaction by freely adjusting the ratio (area) of the wide viewing angle area and the narrow viewing angle area in the first direction and the second direction as well as the position of the wide viewing angle area and the narrow viewing angle area according to a user request or content.

A display panel according to some aspects may include a plurality of pixel blocks including a plurality of subpixels disposed in a display area, a bezel area disposed outside the display area, and a plurality of mode control line sets individually connected to the plurality of pixel blocks, wherein each of the plurality of mode control line sets includes a first mode control line for supplying a first mode control signal and a second mode control line for supplying a second mode control signal, and wherein each of the plurality of subpixels includes a driving transistor connected to a first power line, a first light emitting device connected to the driving transistor through a first mode control transistor controlled by the first mode control signal, a second light emitting device connected to the driving transistor through a second mode control transistor controlled by the second mode control signal, a first lens region disposed on the first light emitting device, and a second lens region disposed on the second light emitting device, wherein the first lens region and the second lens region differently control a viewing angle in a first direction.

In the display panel according to some aspects, each subpixel may control the viewing angle of the first direction to a wide viewing angle through the first lens region by driving the first light emitting device when the first mode control signal is activated, and each subpixel may control the viewing angle of the first direction to a narrow viewing angle through the second lens region by driving the second light emitting device when the second mode control signal is activated.

In the display panel according to some aspects, in each of the plurality of pixel blocks, the first mode control line may include a first mode control line of a first type disposed in the first direction and a first mode control line of a second type disposed in a second direction, and the second mode control line may include a second mode control line of the first type disposed in the first direction and a second mode control line of the second type disposed in the second direction.

In the display panel according to some aspects, the first mode control line of the first type and the second mode control line of the first type, which are disposed in any one pixel block among the plurality of pixel blocks, may be separated from the second mode control line of the second type and the first mode control line of the first type disposed in another pixel block adjacent to the first direction.

In the display panel according to some aspects, the first mode control line of the second type and the second mode control line of the second type, which are disposed in any one pixel block among the plurality of pixel blocks, may extend in the second direction to other pixel blocks adjacent in the second direction.

In the display panel according to some aspects, in each of the plurality of pixel blocks, the first mode control line of the second type and the second mode control line of the second type may be disposed in parallel with a second power line between each of unit pixels and extend in the second direction.

In the display panel according to some aspects, in each of the subpixels, a data line, an initialization voltage line, and the first power line connected to each subpixel may extend in the second direction.

In the display panel according to some aspects, in a first type pixel area included in each pixel block, the first mode control line of the first type and the first mode control line of the second type may be connected to each other through a first contact hole of an insulating layer, and the second mode control line of the first type and the second mode control line of the second type may be connected to each other through a second contact hole of an insulating layer.

In the display panel according to some aspects, in a second type pixel area included in each pixel block, the first mode control line of the first type may intersect the first mode control line of the second type with an insulating layer interposed therebetween, and the second mode control line of the first type may intersect the second mode control line of the second type with an insulating layer interposed therebetween.

In the display panel according to some aspects, in a third type pixel area included in each pixel block, the first mode control line of the first type may be separated from the first mode control line of the first type disposed in the adjacent pixel block, and the second mode control line of the first type may be separated from the second mode control line of the first type disposed in the adjacent pixel block.

In the display panel according to some aspects, each of the plurality of mode control line sets may include a first mode control line of a third type and a second mode control line of a third type disposed in the bezel area, an electrostatic prevention circuit connected to each of the first mode control line of the third type and the second mode control line of the third type, and a lighting test circuit connected to the first mode control line of the third type and the second mode control line of the third type.

In the display panel according to some aspects, the first mode control line of the third type and the second mode control line of the third type may be disposed in a data link area disposed in the bezel area or disposed outside the data link area.

In the display panel according to some aspects, each of the plurality of mode control line sets may include a first mode control line of a fourth type arranged in the first direction in the bezel area and configured to connect the first mode control line of the third type and the first mode control line of the second type, and a second mode control line of a fourth type arranged in the first direction in the bezel area and configured to connect the second mode control line of the third type and the second mode control line of the second type.

In the display panel according to some aspects, each subpixel may include a storage capacitor connected to a gate electrode of the driving transistor, a first switching transistor configured to supply a data voltage of the data line to a first electrode of the storage capacitor in response to a first scan signal of a first gate line, a second switching transistor configured to connect the driving transistor in a diode structure in response to a second scan signal of a second gate line, a third switching transistor configured to supply an initialization voltage of the initialization voltage line to the first electrode of the storage capacitor in response to an emission control signal of a third gate line, a fourth switching transistor configured to connect the driving transistor and the first and second mode control transistors in response to the emission control signal of the third gate line, a fifth switching transistor configured to supply the initialization voltage of the initialization voltage line to an anode electrode of the second light emitting device in response to the second scan signal of the second gate line, and a seventh switching transistor configured to supply the initialization voltage of the initialization voltage line to an anode electrode of the first light emitting device in response to the second scan signal of the second gate line.

In the display panel according to some aspects, the first light emitting device may include a first light emitting area, and the first lens may overlap the first light emitting area and may have a bottom surface which is wider than that of the first light emitting area.

In the display panel according to some aspects, the second light emitting device may include a plurality of second light emitting areas, the second lens region may include a plurality of second lenses overlapped with the plurality of second light emitting areas, and each of the plurality of second lenses may include a bottom surface which is wider than that of each of the plurality of second light emitting areas.

In the display panel according to some aspects, the plurality of subpixels may include a first color subpixel, a second color subpixel, and a third color subpixel, the size of the first lens in each of the first, second, and third color subpixels may be different from each other, and the number of second lenses in each of the first, second, and third color subpixels may be different from each other.

A display apparatus according to some aspects may include a display panel, a data driver disposed in a bezel area and configured to drive data lines disposed in a display area, wherein the data driver individually supplies a first mode control signal and a second mode control signal to each of a plurality of mode control line sets.

Further examples are set out in the clauses below:
1. A display panel comprising: a plurality of pixel blocks including a plurality of subpixels disposed in a display area; a bezel area disposed outside the display area; and
   a plurality of mode control line sets individually connected to the plurality of pixel blocks, wherein each of the plurality of mode control line sets includes a first mode control line for supplying a first mode control signal and a second mode control line for supplying a second mode control signal, and wherein each of the plurality of subpixels includes:
   a driving transistor connected to a first power line; a first light emitting device connected to the driving transistor through a first mode control transistor controlled by the first mode control signal; a second light emitting device connected to the driving transistor through a second mode control transistor controlled by the second mode control signal; a first lens region disposed on the first light emitting device; and a second lens region disposed on the second light emitting device, wherein the first lens region and the second lens region differently control a viewing angle in a first direction.
2. The display panel according to clause 1, wherein each subpixel controls the viewing angle of the first direction to a wide viewing angle through the first lens region by driving the first light emitting device when the first mode control signal is activated, and
   each subpixel controls the viewing angle of the first direction to a narrow viewing angle through the second lens region by driving the second light emitting device when the second mode control signal is activated.
3. The display panel according to clause 1 or 2, wherein, in each of the plurality of pixel blocks, the first mode control line includes a first mode control line of a first type disposed in the first direction and a first mode control line of a second type disposed in a second direction, and the second mode control line includes a second mode control line of the first type disposed in the first direction and a second mode control line of the second type disposed in the second direction.
4. The display panel according to clause 3, wherein the first mode control line of the first type and the second mode control line of the first type, which are disposed in any one pixel block among the plurality of pixel blocks, are separated from the second mode control line of the second type and the first mode control line of the first type disposed in another pixel block adjacent to the first direction.
5. The display panel according to clause 3 or 4, wherein the first mode control line of the second type and the second mode control line of the second type, which are disposed in any one pixel block among the plurality of pixel blocks, extend in the second direction to other pixel blocks adjacent in the second direction.
6. The display panel according to any one of clauses 3-5, wherein, in each of the plurality of pixel blocks, the first mode control line of the second type and the second mode control line of the second type are disposed in parallel with a second power line between each of unit pixels and extend in the second direction.
7. The display panel according to any one of clauses 3-6, wherein, in each of the subpixels, a data line, an initialization voltage line, and the first power line connected to each subpixel extend in the second direction.
8. The display panel according to any one of clauses 3-7, wherein, in a first type pixel area included in each pixel block, the first mode control line of the first type and the first mode control line of the second type are connected to each other through a first contact hole of an insulating layer, and the second mode control line of the first type and the second mode control line of the second type are connected to each other through a second contact hole of an insulating layer.
9. The display panel according to any one of clauses 3-8, wherein, in a second type pixel area included in each pixel block, the first mode control line of the first type intersects the first mode control line of the second type with an insulating layer interposed therebetween, and the second mode control line of the first type intersects the second mode control line of the second type with an insulating layer interposed therebetween.
10. The display panel according to any one of clauses 3-9, wherein, in a third type pixel area included in each pixel block, the first mode control line of the first type is separated from the first mode control line of the first type disposed in the adjacent pixel block, and
   the second mode control line of the first type is separated from the second mode control line of the first type disposed in the adjacent pixel block.
11. The display panel according to any one of clauses 3-10, wherein each of the plurality of mode control line sets includes: a first mode control line of a third type and a second mode control line of a third type disposed in the bezel area; an electrostatic prevention circuit connected to each of the first mode control line of the third type and the second mode control line of the third type; and a lighting test circuit connected to the first mode control line of the third type and the second mode control line of the third type.
12. The display panel according to clause 11, wherein the first mode control line of the third type and the second mode control line of the third type are disposed in a data link area disposed in the bezel area or disposed outside the data link area.
13. The display panel according to clause 11 or clause 12, wherein each of the plurality of mode control line sets includes: a first mode control line of a fourth type arranged in the first direction in the bezel area and configured to connect the first mode control line of the third type and the first mode control line of the second type; and
   a second mode control line of a fourth type arranged in the first direction in the bezel area and configured to connect the second mode control line of the third type and the second mode control line of the second type.
14. The display panel according to any one of the preceding clauses, wherein each subpixel includes: a storage capacitor connected to a gate electrode of the driving transistor; a first switching transistor configured to supply a data voltage of the data line to a first electrode of the storage capacitor in response to a first scan signal of a first gate line; a second switching transistor configured to connect the driving transistor in a diode structure in response to a second scan signal of a second gate line; a third switching transistor configured to supply an initialization voltage of the initialization voltage line to the first electrode of the storage capacitor in response to an emission control signal of a third gate line; a fourth switching transistor configured to connect the driving transistor and the first and second mode control transistors in response to the emission control signal of the third gate line; a fifth switching transistor configured to supply the initialization voltage of the initialization voltage line to an anode electrode of the second light emitting device in response to the second scan signal of the second gate line; and a seventh switching transistor configured to supply the initialization voltage of the initialization voltage line to an anode electrode of the first light emitting device in response to the second scan signal of the second gate line.
15. The display panel according to any one of the preceding clauses, wherein the first light emitting device includes a first light emitting area, and the first lens overlaps the first light emitting area and has a bottom surface which is wider than that of the first light emitting area.
16. The display panel according to any one of the preceding clauses, wherein the second light emitting device includes a plurality of second light emitting areas, the second lens region includes a plurality of second lenses overlapped with the plurality of second light emitting areas, and each of the plurality of second lenses includes a bottom surface which is wider than that of each of the plurality of second light emitting areas.
17. The display panel according to any one of the preceding clauses, wherein the plurality of subpixels includes a first color subpixel, a second color subpixel, and a third color subpixel,
   the size of the first lens in each of the first, second, and third color subpixels is different from each other, and the number of second lenses in each of the first, second, and third color subpixels is different from each other.
18. A display apparatus comprising: a display panel disclosed in any one of clauses 1 to 17; and a data driver disposed in a bezel area and configured to drive data lines disposed in a display area, wherein the data driver individually supplies a first mode control signal and a second mode control signal to each of a plurality of mode control line sets.

The above-described feature, structure, and effect of the present disclosure are included in at least one example of the present disclosure, but are not limited to only one example. Furthermore, the feature, structure, and effect described in at least one example of the present disclosure may be implemented through combination or modification of other examples by those skilled in the art. Therefore, content associated with the combination and modification should be construed as being within the scope of the present disclosure.

It will be apparent to those skilled in the art that various modifications and variations can be made in the present disclosure without departing from the scope of the disclosures. Thus, it is intended that the present disclosure covers the modifications and variations of this disclosure provided they come within the scope of the appended claims and their equivalents.

## Claims

1. A display panel comprising:
a plurality of pixel blocks including a plurality of subpixels disposed in a display area;
a bezel area disposed outside the display area; and
a plurality of mode control line sets individually connected to the plurality of pixel blocks,
wherein each of the plurality of mode control line sets includes a first mode control line for supplying a first mode control signal and a second mode control line for supplying a second mode control signal, and
wherein each of the plurality of subpixels includes:
a driving transistor connected to a first power line;
a first light emitting device connected to the driving transistor through a first mode control transistor controlled by the first mode control signal;
a second light emitting device connected to the driving transistor through a second mode control transistor controlled by the second mode control signal;
a first lens region disposed on the first light emitting device; and
a second lens region disposed on the second light emitting device,
wherein the first lens region and the second lens region differently control a viewing angle in a first direction.

2. The display panel according to claim 1,
wherein each subpixel controls the viewing angle of the first direction to a wide viewing angle through the first lens region by driving the first light emitting device when the first mode control signal is activated, and
each subpixel controls the viewing angle of the first direction to a narrow viewing angle through the second lens region by driving the second light emitting device when the second mode control signal is activated.

3. The display panel according to claim 1 or 2, wherein, in each of the plurality of pixel blocks, the first mode control line includes a first mode control line of a first type disposed in the first direction and a first mode control line of a second type disposed in a second direction, and the second mode control line includes a second mode control line of the first type disposed in the first direction and a second mode control line of the second type disposed in the second direction.

4. The display panel according to claim 3, wherein the first mode control line of the first type and the second mode control line of the first type, which are disposed in any one pixel block among the plurality of pixel blocks, are separated from the second mode control line of the second type and the first mode control line of the first type disposed in another pixel block adjacent to the first direction.

5. The display panel according to claim 3, wherein the first mode control line of the second type and the second mode control line of the second type, which are disposed in any one pixel block among the plurality of pixel blocks, extend in the second direction to other pixel blocks adjacent in the second direction; and/or optionally
wherein, in each of the plurality of pixel blocks, the first mode control line of the second type and the second mode control line of the second type are disposed in parallel with a second power line between each of unit pixels and extend in the second direction.

6. The display panel according to any one of claims 3-5, wherein, in each of the subpixels, a data line, an initialization voltage line, and the first power line connected to each subpixel extend in the second direction.

7. The display panel according to any one of claims 3-6,
wherein, in a first type pixel area included in each pixel block,
the first mode control line of the first type and the first mode control line of the second type are connected to each other through a first contact hole of an insulating layer, and
the second mode control line of the first type and the second mode control line of the second type are connected to each other through a second contact hole of an insulating layer.

8. The display panel according to claim 3,
wherein, in a second type pixel area included in each pixel block,
the first mode control line of the first type intersects the first mode control line of the second type with an insulating layer interposed therebetween, and
the second mode control line of the first type intersects the second mode control line of the second type with an insulating layer interposed therebetween; and/or optionally
wherein, in a third type pixel area included in each pixel block,
the first mode control line of the first type is separated from the first mode control line of the first type disposed in the adjacent pixel block, and
the second mode control line of the first type is separated from the second mode control line of the first type disposed in the adjacent pixel block.

9. The display panel according to claim 3, wherein each of the plurality of mode control line sets includes:
a first mode control line of a third type and a second mode control line of a third type disposed in the bezel area;
an electrostatic prevention circuit connected to each of the first mode control line of the third type and the second mode control line of the third type; and
a lighting test circuit connected to the first mode control line of the third type and the second mode control line of the third type.

10. The display panel according to claim 9, wherein the first mode control line of the third type and the second mode control line of the third type are disposed in a data link area disposed in the bezel area or disposed outside the data link area.

11. The display panel according to claim 9 or claim 10,
wherein each of the plurality of mode control line sets includes:
a first mode control line of a fourth type arranged in the first direction in the bezel area and configured to connect the first mode control line of the third type and the first mode control line of the second type; and
a second mode control line of a fourth type arranged in the first direction in the bezel area and configured to connect the second mode control line of the third type and the second mode control line of the second type.

12. The display panel according to any one of the preceding claims, wherein each subpixel includes:
a storage capacitor connected to a gate electrode of the driving transistor;
a first switching transistor configured to supply a data voltage of the data line to a first electrode of the storage capacitor in response to a first scan signal of a first gate line;
a second switching transistor configured to connect the driving transistor in a diode structure in response to a second scan signal of a second gate line;
a third switching transistor configured to supply an initialization voltage of the initialization voltage line to the first electrode of the storage capacitor in response to an emission control signal of a third gate line;
a fourth switching transistor configured to connect the driving transistor and the first and second mode control transistors in response to the emission control signal of the third gate line;
a fifth switching transistor configured to supply the initialization voltage of the initialization voltage line to an anode electrode of the second light emitting device in response to the second scan signal of the second gate line; and
a seventh switching transistor configured to supply the initialization voltage of the initialization voltage line to an anode electrode of the first light emitting device in response to the second scan signal of the second gate line.

13. The display panel according to any one of the preceding claims,
wherein the first light emitting device includes a first light emitting area, and
the first lens overlaps the first light emitting area and has a bottom surface which is wider than that of the first light emitting area.

14. The display panel according to any one of the preceding claims,
wherein the second light emitting device includes a plurality of second light emitting areas,
the second lens region includes a plurality of second lenses overlapped with the plurality of second light emitting areas, and
each of the plurality of second lenses includes a bottom surface which is wider than that of each of the plurality of second light emitting areas; and/or optionally
wherein the plurality of subpixels includes a first color subpixel, a second color subpixel, and a third color subpixel,
the size of the first lens in each of the first, second, and third color subpixels is different from each other, and
the number of second lenses in each of the first, second, and third color subpixels is different from each other.

15. A display apparatus comprising:
a display panel disclosed in any one of claims 1 to 14; and
a data driver disposed in a bezel area and configured to drive data lines disposed in a display area,
wherein the data driver individually supplies a first mode control signal and a second mode control signal to each of a plurality of mode control line sets.
